# EUROPEAN PATENT SPECIFICATION

(11) **EP 1 727 275 B1**
(45) Date of publication and mention of the grant of the patent: **01.12.2010**
(21) Application number: 05710542.1
(22) Date of filing: 16.02.2005
(51) Int. Cl.: H03H 9/05, H03H 9/10

(54) **PIEZO-OSCILLATOR AND MANUFACTURING METHOD THEREOF**
PIEZOOSZILLATOR UND HERSTELLUNGSVERFAHREN DAFÜR
PIEZO-OSCILLATEUR ET SA METHODE DE FABRICATION

(30) Priority: 17.02.2004 JP 2004040352; 30.06.2004 JP 2004193818; 12.01.2005 JP 2005005606
(43) Date of publication of application: 29.11.2006
(73) Proprietor: Seiko Epson Corporation, Tokyo 163-0811 (JP)
(72) Inventor: CHIBA, Seiichi, c/o SEIKO EPSON CORPORATION, Suwa-Shi, Nagano 3928502 (JP); MIYAZAKI, Katsuhiko, c/o SEIKO EPSON CORPORATION, Suwa-Shi, Nagano 3928502 (JP); HAYASHI, Mutsuo, c/o SEIKO EPSON CORPORATION, Suwa-shi, Nagano 3928502 (JP)
(74) Representative: HOFFMANN EITLE
(86) International application number: PCT/JP2005/002839
(87) International publication number: WO 2005/078914

(56) References cited:
- EP-A- 0 831 591
- JP-A- 9 167 918
- JP-A- 10 098 151
- JP-A- 11 136 034
- JP-A- 2001 320 240
- JOSHI R ET AL: "Plastic chip carrier package" ELECTRONIC COMPONENTS AND TECHNOLOGY CONFERENCE, 1996. PROCEEDINGS, 28 May 1996 (1996-05-28), - 31 May 1996 (1996-05-31) pages 772-776, XP010167199
- JANTUNEN H ET AL: "Design aspects of microwave components with LTCC technique" JOURNAL OF THE EUROPEAN CERAMIC SOCIETY, ELSEVIER SCIENCE PUBLISHERS, vol. 23, no. 14, 1 January 2003 (2003-01-01), pages 2541-2548, XP004446276

## Description

### (Technical Field)

The present invention relates to a piezoelectric oscillator having a piezoelectric resonator and an oscillator circuit element.

### (Background)

Piezoelectric oscillators have been widely used for small information equipment, such as hard-disc drives (HDD), mobile computers, and integrated circuit (IC) cards, and mobile communications equipment, such as mobile phones, car-phones, and paging systems.

A related art piezoelectric oscillator includes a piezoelectric resonator element and an oscillator circuit element that are housed inside a package. The surface of the piezoelectric resonator element has an excitation electrode that is electrically coupled to an electrode film laid out inside the package. The electrode film is electrically coupled to the oscillator circuit element. Accordingly, the piezoelectric resonator element and the oscillator circuit element are electrically coupled to each other. Operations of the piezoelectric resonator element is thus controlled by the oscillator circuit element.

As the size of such a piezoelectric oscillator has been considerably reduced recently, it becomes difficult to house a piezoelectric resonator element and an oscillator circuit element within one package.

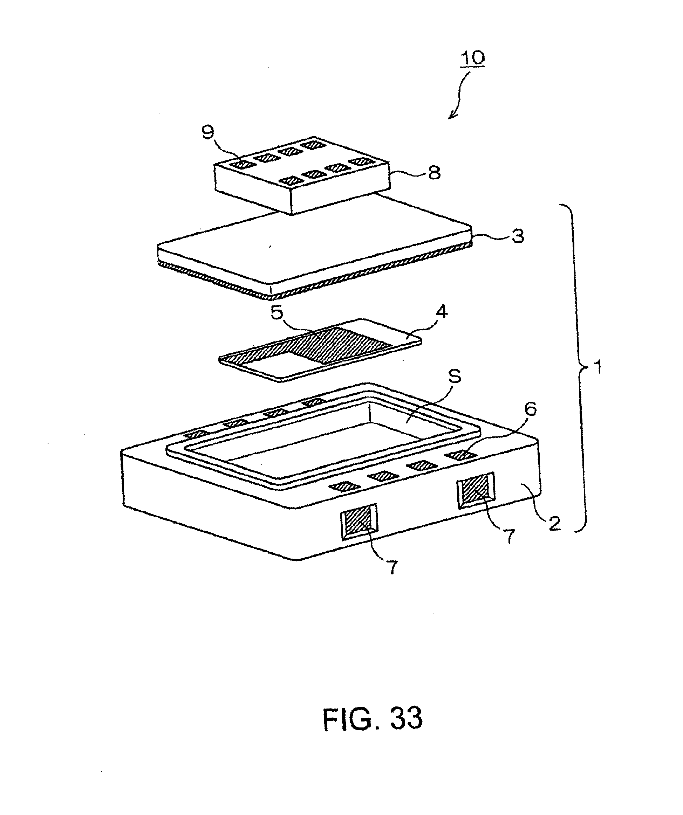

A piezoelectric oscillator 10 as shown in Fig. 33 has been filed for a patent to address this issue. Fig. 33 is an exploded perspective view of the piezoelectric oscillator 10 (see Patent Document 1, for example).

The piezoelectric oscillator 10 includes a piezoelectric resonator 1 and an oscillator circuit element 8.

The piezoelectric resonator 1 houses a piezoelectric resonator element 4 in a space S inside a package 2 made from multilayered ceramic substrates, and is sealed by a lid 3. The surface of the piezoelectric resonator element 4 has an excitation electrode 5. Electrically coupled to this excitation electrode 5 is an electrode film (not shown) laid out with the multilayered ceramic substrates. An electrode pad 6 is provided to the opening end of the package 2.

An oscillator circuit element 8 is mounted on the upper surface of the lid 3 of the piezoelectric resonator 1. A terminal 9 of the oscillator circuit element 8 is coupled to the electrode pad 6 with a bonding wire (not shown). The side of the piezoelectric oscillator 10 has a controlling terminal 7 electrically coupled to part of the electrode pad 6 with an electrode film (not shown) laid out inside the package 2. Data for controlling operations of the piezoelectric resonator element 4 are written in the oscillator circuit element 8 via the controlling terminal 7.

Consequently, the piezoelectric resonator element 4 and the oscillator circuit element 8 do not have to be housed together in the small space S inside the piezoelectric oscillator 10, which makes it easy to manufacture the piezoelectric oscillator even its size is reduced.

### (Patent Document 1)

Japanese Unexamined Patent Publication No. 2001-320240.

Document JP2001320240A discloses a piezoelectric oscillator which is low cost and which can be miniaturized. The piezoelectric oscillator includes a piezoelectric resonator element and an oscillator circuit element. Both may be housed in a package which is sealed by a lid. Electrode pads which may be coupled to the piezoelectric resonator element are arranged at an upper side of the package. A support electrode which holds the piezoelectric resonator element is connected to a terminal electrode and serves as a first electrical connection of the piezoelectric resonator element, and another support electrode which also holds the piezoelectric resonator element is connected to another terminal electrode and serves as a second electrical connection of the piezoelectric resonator element.

In document JP11136034A a piezoelectric oscillator is described which can be miniaturized and which is adapted for yield improvement and cost effectiveness. The piezoelectric oscillator includes a semiconductor circuit and a piezoelectric resonator. The piezoelectric resonator is arranged atop a substrate. In the publication of Joshi, R. et al., titled "Plastic Chip Carrier Package" published in the proceedings of the Electronic Components and Technology Conference, May 1996, pages 772-776, a chip carrier package adapted for surface mounting is disclosed. The package construction is used for microelectronic devices. In the publication of Janthunen, H. et al. titled "Design Aspects of Microwave Components with LTCC Technique" published in the Journal of the European Ceramic Society, Vol. 23, No. 14, January 2003, pages 2541- 2548, design aspects of microwave components with low temperature co-fired ceramic technology are described. Microwave resonators are disclosed which are embedded in ceramic chips the electrical performance of which is evaluated.

### (Disclosure of the Invention)

To electrically couple the oscillator circuit element 8 and the piezoelectric resonator element 4, the piezoelectric oscillator 10 has to include the electrode film (not shown) laid out with the multilayered substrates of the package 2, and also include the electrode pad 6 on its opening end and the controlling terminal 7 on its side.

Therefore, the piezoelectric resonator 1 exclusively used for the piezoelectric oscillator is required, which can increase production costs, even though a more compact and versatile piezoelectric resonator is available.

To address the above-mentioned issue, the invention aims to provide a piezoelectric oscillator whose size can be reduced and whose production cost can be saved by using a versatile piezoelectric resonator.

In a piezoelectric oscillator according to the invention, at least a conductive part except for a mounting terminal portion is sealed with resin. The piezoelectric oscillator includes a substrate whose bottom is provided with the mounting terminal portion; a piezoelectric resonator housing a piezoelectric resonator element in a package fixed on the upper surface of the substrate and sealed with a lid, and having an external terminal portion electrically coupled to the piezoelectric resonator element on the surface of the package; and an oscillator circuit element included in an oscillator circuit and fixed on a side of the package opposite to another side facing the substrate. The substrate has a conductive terminal portion electrically coupled to the mounting terminal portion on its upper surface. The external terminal portion and the conductive terminal portion are electrically coupled to the oscillator circuit element.

According to the invention, the piezoelectric oscillator includes the piezoelectric resonator housing the piezoelectric resonator element in the package sealed with the lid and having the external terminal portion electrically coupled to the piezoelectric resonator element on the surface of the package by means of an electrode portion exposed to an inner space of the package, and the oscillator circuit element included in the oscillator circuit and fixed on a side of the package opposite to another side facing the substrate. Therefore, the piezoelectric resonator element and the oscillator circuit element do not have to be housed together in a small space inside the package, which makes it easy to manufacture the oscillator even its size is reduced.

The substrate is provided with the mounting terminal portion. On the upper surface of the substrate, the conductive terminal portion electrically coupled to the mounting terminal portion is also provided. The external terminal portion and the conductive terminal portion are electrically coupled to the oscillator circuit element. In other words, the substrate is provided with the mounting terminal portion in place of related art mounting terminals provided to a piezoelectric resonator. By providing the conductive terminal portion electrically coupled to the mounting terminal portion on the upper surface of the substrate, the mounting terminal portion, the oscillator circuit element, and the external terminal portion are electrically coupled outside the package. This makes it possible to electrically couple the mounting terminal portion, the oscillator circuit element, and the piezoelectric resonator without an electrode pad on an opening end with an electrode film laid out in the package as in related art.

Accordingly, the present aspect provides a piezoelectric oscillator whose size can be reduced and whose production cost can be saved by using a versatile piezoelectric resonator.

According to a first aspect of the invention, in the piezoelectric oscillator, the piezoelectric resonator is fixed to make the external terminal portion face the upper surface of the substrate.

The oscillator circuit element is fixed to the upper surface of the lid included in the piezoelectric resonator. The substrate is provided in an area facing the external terminal portion, and includes a coupling terminal portion extending from the area to a periphery. Each of the coupling terminal portion and the conductive terminal portion is coupled to terminal portions of the oscillator circuit element by wire bonding.

According to this first aspect of the invention, the piezoelectric resonator is fixed to make the external terminal portion face the upper surface of the substrate, and the substrate is provided in an area facing the external terminal portion, and includes a coupling terminal portion extending from the area to a periphery. Consequently, the external terminal portion included in the piezoelectric resonator is electrically connected to the coupling terminal portion on the periphery of the substrate. Each of the coupling terminal portion and the conductive terminal portion, coupled to the mounting terminal portion, is electrically coupled to the oscillator circuit element by wire bonding. This makes it possible to electrically couple the mounting terminal portion, the oscillator circuit element, and the piezoelectric resonator without laying out an electrode in the package and providing an electrode pad on an opening end as in related art.

According to a second aspect of the invention, in contrast to the piezoelectric oscillator of the first aspect, the piezoelectric resonator is fixed to make the lid face the upper surface of the substrate. The oscillator circuit element is fixed to the side of the piezoelectric resonator having the external terminal portion, and has terminal portions wire bonded to the external terminal portion and the conductive terminal portion.

According to this second aspect of the invention, the piezoelectric resonator is fixed to make the lid face the upper surface of the substrate, the oscillator circuit element is fixed to the side of the piezoelectric resonator having the external terminal portion, and the oscillator circuit element is also coupled to the external terminal portion and the conductive terminal portion, electrically coupled to the mounting terminal portion, included in the piezoelectric resonator by wire bonding. Accordingly, the piezoelectric resonator and the oscillator circuit element, and the oscillator circuit element and the mounting terminal portion are electrically connected to each other. This makes it possible to electrically couple the mounting terminal portion, the oscillator circuit element, and the piezoelectric resonator without laying out an electrode in the package and providing an electrode pad on an opening end.

Furthermore, the oscillator circuit element is fixed to the side having the external terminal portion according to the second aspect of the invention. This makes it possible to wire-bond the external terminal portion and the oscillator circuit element directly without using the coupling terminal portion on the substrate in the first aspect, and thereby shortening a distance between the external terminal portion and the oscillator circuit element and reducing stray capacitance compared to the second aspect.

According to a third aspect of the invention, in the piezoelectric oscillator of the second aspect, the substrate includes a portion defining a hole in an area facing the lid.

Since the substrate includes a hole in an area facing the lid in the third aspect of the invention, the lid is inserted to the hole, and thereby the height of the piezoelectric oscillator can be reduced by the thickness to which the lid is inserted.

According to a fourth aspect of the invention, in the piezoelectric oscillator of any of the first through third aspects, the substrate includes a controlling terminal portion for writing a signal that controls operation of the piezoelectric resonator element in the oscillator circuit element on an upper surface. The controlling terminal portion and the oscillator circuit element are coupled by wire bonding.

Since the controlling terminal portion for writing a signal that controls operation of the piezoelectric resonator element in the oscillator circuit element is provided on the upper surface of the substrate in the fourth aspect of the invention, a generic piezoelectric resonator can be used to provide a piezoelectric oscillator including such a controlling terminal portion without laying out an electrode in the package and exposing it at a side as in related art.

According to a fifth aspect of the invention, in the piezoelectric oscillator of the fourth aspect, a write-in terminal electrically coupled to the controlling terminal portion is provided to a bottom of the substrate.

Since the write-in terminal electrically coupled to the controlling terminal portion is provided to the bottom of the substrate in the fifth aspect of the invention, the write-in terminal can be formed widely on the bottom of the substrate only having the mounting terminal portion and thus having a wide blank area. Accordingly, a contact failure of a write-in probe pin can be reduced, and thereby increasing yields.

According to a sixth aspect of the invention, in the piezoelectric oscillator of any of the first through fifth aspects, an electrode is provided to a surface of the piezoelectric resonator, and between a terminal portion of the oscillator circuit element and at least one of the external terminal portion to be coupled to the terminal portion and a terminal on the substrate.

The electrode is provided to the surface of the piezoelectric resonator, and between a terminal portion of the oscillator circuit element and at least one of the external terminal portion to be coupled to the terminal portion and a terminal on the substrate in the sixth aspect of the invention. Therefore, even if a bonding wire is difficult to lay out due to terminal-portion configuration, it is possible to lay out such a bonding wire using an electrode pattern by wire-bonding the terminal portion of the oscillator circuit element and the pattern, and wire-bonding the pattern and the controlling terminal portion. This makes it easy to lay out a bonding wire between individual terminals.

The piezoelectric resonator of the sixth aspect has the electrode pattern on its surface, and thereby the complete piezoelectric resonator is not generic in the strict sense. However, since the electrode pattern is provided to the surface of the piezoelectric resonator, it is possible to provide the electrode pattern afterwards to the surface of the piezoelectric resonator that is generic. Even without providing the electrode pattern afterwards to the surface of the piezoelectric resonator that is generic, the electrode pattern is not laid out inside the package as in related art. Therefore, manufacturing costs can be reduced compared to related art and smaller packaging can be achieved, and thereby providing the same effects as the first to fifth aspects do.

According to an seventh aspect of the invention, in the piezoelectric oscillator of any of the first through sixth aspects, the piezoelectric resonator includes a conductive body along a thickness direction on a surface of the resonator. Through the conductive body, the electrode pattern provided between a terminal portion of the oscillator circuit element and a terminal on the substrate is electrically coupled to the terminal on the substrate.

The piezoelectric resonator includes a conductive body along a thickness direction on a surface of the resonator, and the electrode pattern provided between a terminal portion of the oscillator circuit element and a terminal on the substrate is electrically coupled to the terminal on the substrate through the conductive body in the seventh aspect. Therefore, by wire-bonding the electrode pattern and the terminal portion of the oscillator circuit element, the terminal portion of the oscillator circuit element is electrically coupled to the terminal on the substrate through the electrode pattern and the conductive body. Accordingly, a space for laying out bonding wires is no more required between the piezoelectric resonator and the substrate, thereby reducing the size of the piezoelectric oscillator.

According to an eight aspect of the invention, in the piezoelectric oscillator of any of the first through seventh aspects, the substrate includes a concave portion in which the piezoelectric resonator is fixed.

Since the substrate includes a concave portion in which the piezoelectric resonator is fixed in the eight aspect, the concave portion serves as a guide for placing the piezoelectric resonator on the substrate, which makes it easy to place the piezoelectric resonator.

Also with the concave portion in which the piezoelectric resonator is fixed, a portion raised from the bottom of the concave portion to which the coupling or conductive terminal portion can be placed, for example, is developed on the substrate. Accordingly, the coupling or conductive terminal portion, for example, is placed closer to the oscillator circuit element than in the other aspects, which makes it easy to lay out a bonding wire. In addition, it is possible to prevent an adhesive to fix the piezoelectric resonator to the substrate from flowing into the coupling or conductive terminal portion, for example, which prevents wire-bonding contact failure.

According to a ninth aspect of the invention, in the piezoelectric oscillator of the eight aspect, part of the concave portion has a step-free portion.

Since part of the concave portion has a step-free portion in the ninth aspect, the substrate has a horizontally open area instead of being surrounded by a concave wall. The open area can be utilized for mounting various electronic parts. By efficiently mounting the piezoelectric resonator using not only an area surrounded by a concave wall, but also this open area, for example, the size of the piezoelectric oscillator can be reduced.

According to a tenth aspect of the invention, in the piezoelectric oscillator of the eight or ninth aspect, the substrate includes a pair of walls so as to have the concave portion. Ends of the walls are almost as high as the terminal portion of the oscillator circuit element.

Since the substrate includes a pair of walls so as to have the concave portion in the tenth aspect, part of the concave portion has a step-free portion, which provides the same effects as in the tenth aspect.

Since the ends of the walls are almost as high as the terminal portion of the oscillator circuit element, the bonding wire can be further shortened than in the eigth and ninth aspects, by placing the coupling or conductive terminal portion, for example, on the side of the walls in their height direction and wire-bonding the terminal and the terminal portion of the oscillator circuit element.

According to an eleventh aspect of the invention, in the piezoelectric oscillator of any of the first through tenth aspects, a surface of at least one of the substrate and the piezoelectric resonator includes a terminal portion electrically coupled to the oscillator circuit element.

Since the surface of at least one of the substrate and the piezoelectric resonator includes a terminal portion electrically coupled to the oscillator circuit element in the eleventh aspect, by coupling the terminal portion to an electronic part other than the oscillator circuit element, the electronic part and the oscillator circuit element are electrically coupled to each other.

According to a twelfth aspect of the invention, in the piezoelectric oscillator of any of the first through eleventh aspects, part of the mounting terminal portion includes a portion defining a bottomed hole.

Since part of the mounting terminal portion includes a portion defining a bottomed hole in the twelfth aspect, solder or the like for coupling a mounting substrate and the mounting terminal in mounting the piezoelectric oscillator is attached inside the bottomed hole to form a fillet, which increases bonding strength.

A method for manufacturing a piezoelectric oscillator according to a thirteenth aspect of the invention provides a piezoelectric oscillator including a piezoelectric resonator housing a piezoelectric resonator element in a package sealed with a lid and having an external terminal portion electrically coupled to the piezoelectric resonator element on a surface of the package, and an oscillator circuit element included in an oscillator circuit. The method includes providing a substrate for preparing a plate substrate, providing a mounting terminal portion to a bottom of the substrate, and providing a conductive terminal portion and a coupling terminal portion to an upper surface of the substrate, the conductive terminal portion being electrically coupled to the mounting terminal portion, and the coupling terminal portion provided in an area facing the external terminal portion and extending out from the area to a periphery; mounting for coupling the piezoelectric resonator on the upper surface of the substrate; fixing the element for fixing the oscillator circuit element to the lid; wire bonding for coupling terminal portions of the oscillator circuit element to the conductive terminal portion and the coupling terminal portion; and sealing for sealing at least a conductive part, except for the mounting terminal portion, with resin. In providing the substrate, a substrate large enough to place a plurality of piezoelectric resonators, each corresponding to the piezoelectric resonator, is provided. The mounting, conductive, and coupling terminal portions are formed to provide a plurality of piezoelectric oscillators. Mounting, fixing the element, bonding, and sealing are followed by cutting into individual piezoelectric oscillators.

The method of the thirteenth aspect includes providing a substrate for preparing a plate substrate, providing a mounting terminal portion to a bottom of the substrate, and providing a conductive terminal portion and a coupling terminal portion to an upper surface of the substrate, the conductive terminal portion being electrically coupled to the mounting terminal portion, and the coupling terminal portion provided in an area facing the external terminal portion and extending out from the area to a periphery; mounting for coupling the piezoelectric resonator on the upper surface of the substrate; fixing the element for fixing the oscillator circuit element to the lid; and bonding for coupling the terminal portions of the oscillator circuit element with the conductive terminal portion and the coupling terminal portion by wire bonding.

Therefore, the piezoelectric resonator element and the oscillator circuit element do not have to be housed together in a small space inside the package, which makes it easy to manufacture the oscillator even its size is reduced. This makes it possible to electrically couple the mounting terminal portion, the oscillator circuit element, and the external terminal portion without laying out an electrode in the package and providing an electrode pad on an opening end as in related art, so that the piezoelectric oscillator can be provided by using a generic piezoelectric resonator.

In providing the substrate, a substrate large enough to place a plurality of piezoelectric resonators, each corresponding to the piezoelectric resonator, is provided. The mounting, conductive, and coupling terminal portions are formed to provide a plurality of piezoelectric oscillators. Mounting, fixing the element, bonding, and sealing are followed by cutting into individual piezoelectric oscillators. Accordingly, a plurality of piezoelectric oscillators can be provided in a single manufacturing step.

A method for manufacturing a piezoelectric oscillator according to a fourteenth aspect of the invention provides a piezoelectric oscillator including a piezoelectric resonator housing a piezoelectric resonator element in a package sealed with a lid and having an external terminal portion electrically coupled to the piezoelectric resonator element on a surface of the package, and an oscillator circuit element included in an oscillator circuit. The method includes providing a substrate for preparing a plate substrate, providing a mounting terminal portion to a bottom of the substrate, and providing a conductive terminal portion electrically coupled to the mounting terminal portion to an upper surface of the substrate; mounting for coupling the piezoelectric resonator to make the lid face the upper surface of the substrate; fixing an element for fixing the oscillator circuit element to a side of the package having the external terminal portion; wire bonding for coupling terminal portions of the oscillator circuit element to the conductive terminal portion and the external terminal portion; and sealing for sealing at least a conductive part, except for the mounting terminal portion, with resin. In providing the substrate, a substrate large enough to place a plurality of piezoelectric resonators, each corresponding to the piezoelectric resonator, is provided. The mounting and conductive terminal portions are formed to provide a plurality of piezoelectric oscillators. Mounting, fixing the element, bonding, and sealing are followed by cutting into individual piezoelectric oscillators.

The method of the fourteenth aspect includes providing a substrate for preparing a plate substrate, providing a mounting terminal portion to a bottom of the substrate, and providing a conductive terminal portion electrically coupled to the mounting terminal portion to an upper surface of the substrate; mounting for coupling the piezoelectric resonator to make the lid face the upper surface of the substrate; fixing an element for fixing the oscillator circuit element to a side of the package having the external terminal portion; bonding for coupling the terminal portions of the oscillator circuit element with the conductive terminal portion and the external terminal portion by wire bonding; and sealing for sealing at least a conductive part, except for the mounting terminal portion, with resin.

Therefore, as in the thirteenth aspect, the piezoelectric resonator element and the oscillator circuit element do not have to be housed together in a small space inside the package, which makes it easy to manufacture the oscillator even its size is reduced. Also as in the thirteenth aspect, this makes it possible to electrically couple the mounting terminal portion, the oscillator circuit element, and the external terminal portion without laying out an electrode in the package and providing an electrode pad on an opening end, so that the piezoelectric oscillator can be provided by using a generic piezoelectric resonator.

Furthermore, by fixing the piezoelectric resonator to make the lid face the substrate, the oscillator circuit element can be fixed to the side of the package having the external terminal portion. Accordingly, the external terminal portion and the oscillator circuit element can be wire-bonded without providing a coupling terminal portion to the substrate.

In addition, since the external terminal portion and the oscillator circuit element are provided on the same side of the package, it is possible to shorten a distance between the external terminal portion and the oscillator circuit element, and thus reduce stray capacitance than in the thirteenth aspect.

In providing the substrate, a substrate large enough to place a plurality of piezoelectric resonators, each corresponding to the piezoelectric resonator, is provided. The mounting and conductive terminal portions are formed to provide a plurality of piezoelectric oscillators. Mounting, fixing the element, bonding, and sealing are followed by cutting into individual piezoelectric oscillators. Accordingly, a plurality of piezoelectric oscillators can be provided in a single manufacturing step.

According to a fifteenth aspect of the invention, in providing the substrate of the method of the thirteenth or fourteenth aspect, a portion defining a through-hole is provided to the substrate, a conductive member is filled in the through-hole, and the mounting terminal portion and the conductive terminal portion are electrically coupled through the conductive member.

In providing a substrate, a portion defining a through-hole is provided to the substrate, a conductive member is filled in the through-hole, and the mounting terminal portion and the conductive terminal portion are electrically coupled through the conductive member in the fifteenth aspect. Accordingly, when resin is injected in a mold cavity, for example, in sealing after providing the substrate, it is possible to prevent the resin from passing through the through-hole and undesirably flowing out, since the through-hole for electrically coupling the mounting terminal portion and the conductive terminal portion is filled with and blocked up by the conductive member.

### (Brief Description of the Drawings)

Fig. 1 is an exploded perspective view schematically showing a piezoelectric oscillator according to a first embodiment of the invention.
Fig. 2 is a plan view schematically showing the piezoelectric oscillator according to the first embodiment of the invention.
Fig. 3 is a sectional view along line A-A of Fig. 2.
Fig. 4 is a flowchart illustrating an example process for manufacturing the piezoelectric oscillator according to the first embodiment.
Fig. 5 describes Step 1-1 shown in Fig. 4.
Fig. 6 describes Step 2 shown in Fig. 4.
Fig. 7 describes Steps 5 and 6 shown in Fig. 4.
Fig. 8 illustrates another method for manufacturing the piezoelectric oscillator according to the first embodiment.
Fig. 9A is a plan view showing a substrate viewed from one side on which a piezoelectric resonator, an integrated circuit (IC) chip, etc., are mounted. Fig. 9B is a plan view showing the substrate viewed from another side to which a mounting terminal is provided.
Fig. 10 is a section view of the substrate, having an IC-chip-mounted piezoelectric resonator that has been resin-molded, along line J-J of Fig. 9.
Fig. 11 is a plan view schematically showing a modification of the first embodiment.
Fig. 12 shows a modification of the substrate shown in Fig. 5 that illustrates the method for manufacturing the piezoelectric oscillator.
Fig. 13 is a sectional view along line E-E of Fig. 12.
Fig. 14 is a sectional view describing a modification of what is shown in Fig. 13.
Fig. 15 is a sectional view schematically showing a piezoelectric oscillator according to a second modification of the first embodiment of the invention.
Fig. 16 is a plan view schematically showing a piezoelectric oscillator according to a second embodiment of the invention.
Fig. 17 is an exploded view schematically showing the piezoelectric oscillator according to the second embodiment of the invention.
Fig. 18 is a sectional view schematically showing a first modification of the second embodiment, along line F-F of Fig. 16.
Fig. 19 is a sectional view schematically showing a modification of what is shown in Fig. 18.
Fig. 20 is a plan view schematically showing a second modification of the second embodiment of the invention.
Fig. 21 is a plan view schematically showing an exemplary third modification.
Fig. 22 is a plan view schematically showing an exemplary fourth modification.
Fig. 23 is a plan view schematically showing a modification of the piezoelectric oscillator shown in Fig. 20.
Fig. 24 is a plan view schematically showing yet another exemplary modification of the third and fourth modifications.
Fig. 25 is a perspective view partially enlarging a feature in Fig. 24.
Fig. 26 is a plan view schematically showing a piezoelectric oscillator according to a third embodiment of the invention.
Fig. 27 is a sectional view along line B-B of Fig. 26.
Fig. 28 is an exploded perspective view schematically showing a modification of the third embodiment of the invention.
Fig. 29 shows an example substrate according to a modification of the third embodiment of the invention.
Fig. 30 is a plan view schematically showing a piezoelectric oscillator according to a second modification of the third embodiment.
Fig. 31 is a sectional view along line H-H of Fig. 30.
Fig. 32 is a bottom view schematically showing the piezoelectric oscillator according to the second modification of the third embodiment.
Fig. 33 is an exploded perspective view of a related art piezoelectric oscillator.

### (Description of Preferred Embodiments)

Piezoelectric oscillators and manufacturing methods thereof according to preferred embodiments of the invention will be described in detail with reference to the accompanying drawings. Note that what is described below is nothing more than embodiments of the invention, and the invention is not limited thereto.

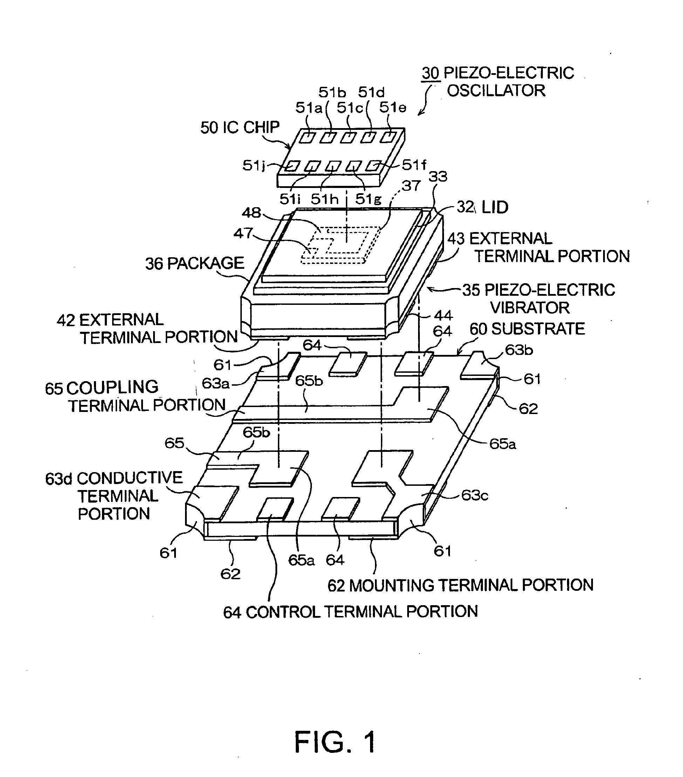

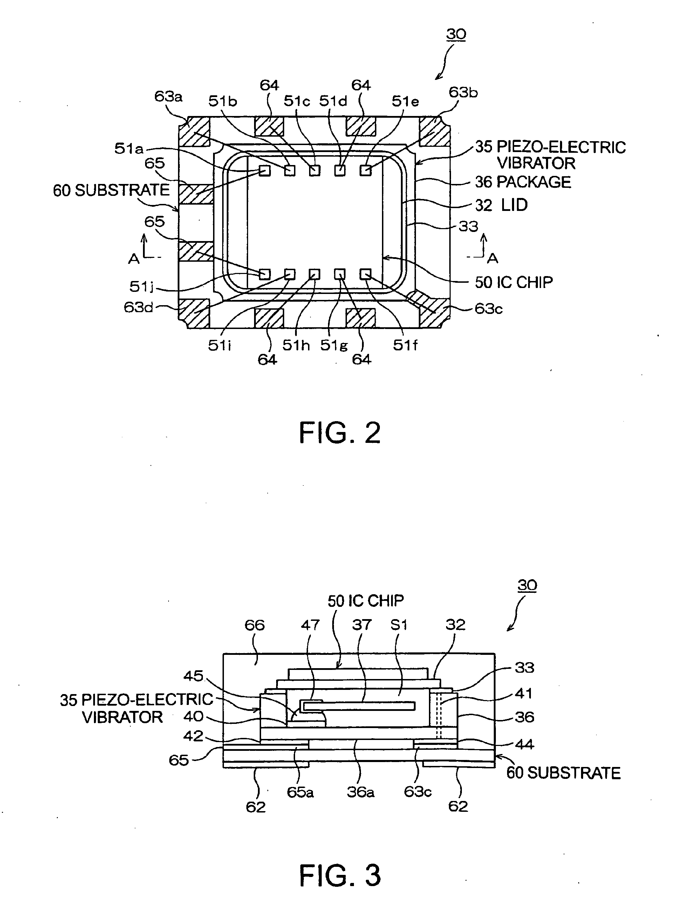

Figs. 1 through 3 show a piezoelectric oscillator according to a first embodiment of the invention. Fig. 1 is an exploded perspective view thereof, Fig. 2 is a plan view thereof, and Fig. 3 is a sectional view thereof along line A-A of Fig. 2. For easy understanding, Figs. 1 and 2 do not show a resin-molded part that will be described later, while Figs. 1 and 3 do not show a bonding wire.

Referring to the drawings, a piezoelectric oscillator 30 includes a piezoelectric resonator 35 housing a piezoelectric resonator element, and an IC chip 50, such as a semiconductor element, as an oscillator circuit element forming an oscillator circuit.

A generic product is used as the piezoelectric resonator 35. Here, a surface-mount piezoelectric resonator housing a piezoelectric resonator element 37 in a package 36 sealed with a lid 32 is used as the piezoelectric resonator 35.

Referring to Figs. 1 and 3, the package 36 is, for example, a plurality of substrates made of aluminum-oxide ceramic green sheets as an insulating material multilayered and then fired to form a sintered body. Part of the substrates has a predetermined inner space S1 inside when multilayered to form a predetermined opening. The package is thus made into a box having a rectangular cross section with an opening.

This inner space S1 houses the piezoelectric resonator element 37.

As shown in Fig. 3, an electrode portion 40 is provided to a lower left portion inside the package 36 so as to be exposed to the inner space S1. The electrode portion 40 is, for example, tungsten metallized and plated thereon with nickel and gold. The electrode portion 40 is provided to the both end portions in the width direction of the package 36 in Fig. 2 (shown as the vertical direction) in the same manner, although the other side is not shown in the drawing.

The electrode portion 40 shown in Fig. 3 is laid out inside the package 36 and coupled to an external terminal portion 42 on a bottom 36a of the package 36 shown in Figs. 1 and 3. In the same manner, the electrode portion on the other side (not shown) is coupled to an external terminal portion 43 on the bottom 36a of the package 36 shown in Fig. 1.

The electrode portion 40 and the other electrode portion (not shown) are electrically coupled to the IC chip 50 as described later, and supply a driving voltage to the piezoelectric resonator element 37. As shown in Fig. 3, a conductive adhesive 45 is applied to the surface of the electrode portion 40. Then on the conductive adhesive 45, an extraction electrode portion 47 provided on the surface of the piezoelectric resonator element 37 is mounted, and then bonded by hardening the conductive adhesive 45. The other electrode portion (not shown) is provided with a conductive adhesive in the same manner, and bonded to an extraction electrode portion 48 for driving the piezoelectric resonator element 37 (see Fig. 1).

Examples of the conductive adhesive 45 include a synthetic resin agent as a bonding adhesive that contains conductive silver or other particles, such as silicone, epoxy, or polyimide conductive adhesives.

The piezoelectric resonator element 37 is made of crystal, for example. Alternatively, lithium tantalate, lithium niobate or other piezoelectric materials can be used. For example, a crystal wafer may be cut in a predetermined direction into rectangular pieces called AT-cut or fork resonator elements. According to the present embodiment, the piezoelectric resonator element 37 shown in Fig. 1 is an AT-cut resonator element having a driving excitation electrode provided on its surface, and the extraction electrodes 47, 48 coupled to the excitation electrode and extracted to the bonding end of the piezoelectric resonator element 37.

The lid 32 seals the piezoelectric resonator element 37 airtight in the inner space S1. The present embodiment uses a plate lid. The lid 32 for sealing is fixed to an opening end of the package 36 with a solder.

According to the present embodiment, the lid 32 is made of a conductive metal material, such as a Fe-Ni-Co alloy, and bonded to the package 36 with a seal ring 33 as shown in Figs. 1 and 3. The lid is exposed to the bottom 36a of the package 36, and also coupled via a conductive portion 41 to a dummy terminal portion 44 that is not electrically coupled to the piezoelectric resonator element 37. By grounding the lid 32 by means of the dummy terminal portion 44 as described later, noise effects from a mother board or the like can be reduced in the present embodiment.

The IC chip 50 as an oscillator circuit element houses an oscillator circuit including an IC (not shown) inside. The IC chip 50 is fixed to a different surface of the package 36 from the one having the external terminal portions 42, 43. The IC chip 50 is fixed to a central portion of the upper surface of the lid 32, opposite to the one having the external terminal portions 42, 43, with an epoxy or silicone adhesive in the present embodiment.

Some terminal portions are provided on the surface of the IC chip 50 opposite to the one bonded to the lid 32. Referring to Figs. 1 and 2, ten terminal portions 51a through 51j are exposed along the periphery of the IC chip 50. It should be understood that the number of the terminal portions the IC chip 50 has may be more or less than this. For example, the terminal portions 51a, 51j of the IC chip 50 are coupled to the piezoelectric resonator 35 as described later in the present embodiment. The terminal portions 51b, 51e, 51i are input/output terminals of the oscillator circuit coupled to mounting terminal portions as described later. The terminal portions 51c, 51d, 51g, 51h write data in the oscillator circuit. The terminal portion 51f is a ground terminal.

Here, the piezoelectric resonator 35 on which the IC chip 50 is mounted is fixed in a way that the bottom 36a having the external terminal portions 42, 43 and the dummy terminal portion 44 faces almost a central portion of the upper surface of the substrate 60 as shown in Figs. 1 and 3.

The substrate 60 is a plate that is, for example, tungsten metallized and printed thereon with a nickel- and gold-plated electrode pattern so as to electrically couple a mounting terminal portion 62 for mounting the piezoelectric oscillator 30 on a mother board, the IC chip 50, and the piezoelectric resonator 35.

Specifically, the substrate 60 is a plate of an insulating material, such as ceramic and epoxy resin, that is a little larger than the piezoelectric resonator 35, and has castellations 61 with a quarter-circle cross section at its four corners as shown in Fig. 1. The castellations 61 are formed based on a circular, guide through-hole or via hole provided at the intersection of cutting lines for cutting a substrate large enough to fix a plurality of piezoelectric resonators on it into pieces corresponding to individual piezoelectric oscillators in making the substrate 60 as described later.

The substrate 60 also includes the mounting terminal portions 62 at its four corner portions, one of which are not shown in Fig. 1, of the bottom. The mounting terminal portions 62 provided at the four corner portions are electrically coupled to conductive terminal portions 63a, 63b, 63c, 63d provided at the four corner portions of the upper periphery of the substrate 60 via a conductive pattern provided on the surface of the castellations 61 at the four corners.

The conductive terminal portion 63a is wire-bonded to the terminal portion 51b of the IC chip 50 with a gold wire, for example. Likewise, the conductive terminal portion 63b is bonded with the terminal portion 51e, the conductive terminal portion 63c is bonded with the terminal portion 51f, and the conductive terminal portion 63d is bonded with the terminal portion 51i.

The conductive terminal portion 63c is laid out on the upper surface of the substrate 60, extending to a portion facing the dummy terminal portion 44 when the piezoelectric resonator 35 is mounted as shown in Fig. 1, so that the lid 32 can be grounded.

The substrate 60 also includes, at its the upper periphery in which the piezoelectric resonator 35 is not mounted, a plurality of controlling terminal portions 64 for writing a signal that controls operations of the piezoelectric resonator element 37 in the IC chip 50. The plurality of controlling terminal portions 64 are wire-bonded to and capable of communicating with the terminal portions 51c, 51d, 51g, 51h of the IC chip 50 with a gold wire, for example. The controlling terminal portions 64 according to the present embodiment write data for temperature compensation in the IC chip 50, so as to provide temperature compensation based on characteristics of the piezoelectric resonator element 37.

Coupling terminal portions 65 are also provided to the upper surface of the substrate 60. The coupling terminal portions 65 electrically couple the piezoelectric resonator 35 and the IC chip 50. Referring to Fig. 1, each of the coupling terminal portions 65 includes a part 65a, facing the external terminal portion 42 or 43 electrically coupled to the piezoelectric resonator element 37, and also includes another part 65b extended out from the part 65a to the periphery. The part 65b is extended to expose the part 65a, which is covered by the bottom of the package 36 when the piezoelectric resonator 35 is fixed to the substrate 60, outward from the side of the package 36. The part 65b is wire-bonded to the terminal portion 51a or 51j of the IC chip 50 with a gold wire, for example.

Referring to Fig. 3, at least conductive portions of the piezoelectric oscillator 30 are sealed by a resin 66, with the exception of the mounting terminal portions 62 at the four bottom corners of the substrate 60. In other words, the resin 66 insulates each terminal and a gold wire, for example, used for the wire bonding that are electrically conductive. According to the present embodiment, the whole structure is sealed by the resin 66 in a way that the bottom of the substrate 60 is exposed so as to insulate conductive portions and protect the inner structure. The resin 66 is formed by injecting synthetic resin with high formability and insulation performance, such as epoxy resin, in a mold to be formed into the shape as shown.

The structure according to the present embodiment has been described. A method for manufacturing the piezoelectric oscillator 30 will now be described.

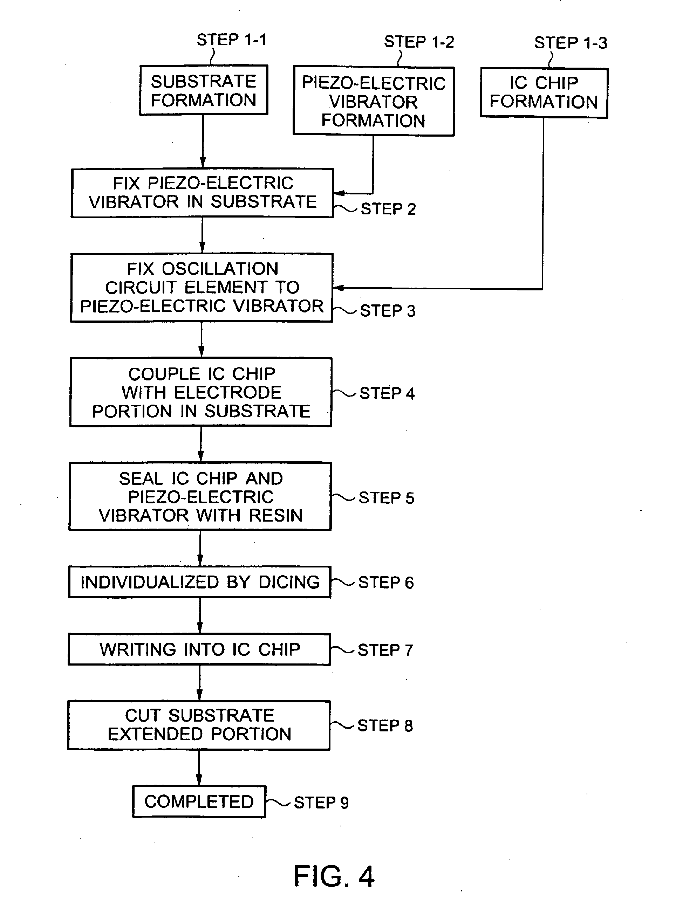

Fig. 4 is a flowchart briefly illustrating an example process for manufacturing the piezoelectric oscillator 30.

Referring to the chart, a piezoelectric resonator, an IC chip, and a substrate on which the piezoelectric resonator is mounted are separately provided.

As the piezoelectric resonator, a plurality of generic piezoelectric resonators are used here. Specifically, a plurality of piezoelectric resonators that are equivalent to the piezoelectric resonator 35 that is of the surface-mount type described above referring to Figs. 1 and 3 are provided, for example, by forming the external terminal portions 42, 43 on the surface of a ceramic package, bonding and then sealing the piezoelectric resonator element 37 airtight with the lid 32, and conducting resonance frequencies and other necessary inspections (Step 1-2).

The IC chip is a semiconductor element housing an oscillator circuit, and not limited to commercially available types, but can be made to order. Here, the type that has been described above referring to Figs. 1 and 3 is provided (Step 1-3).

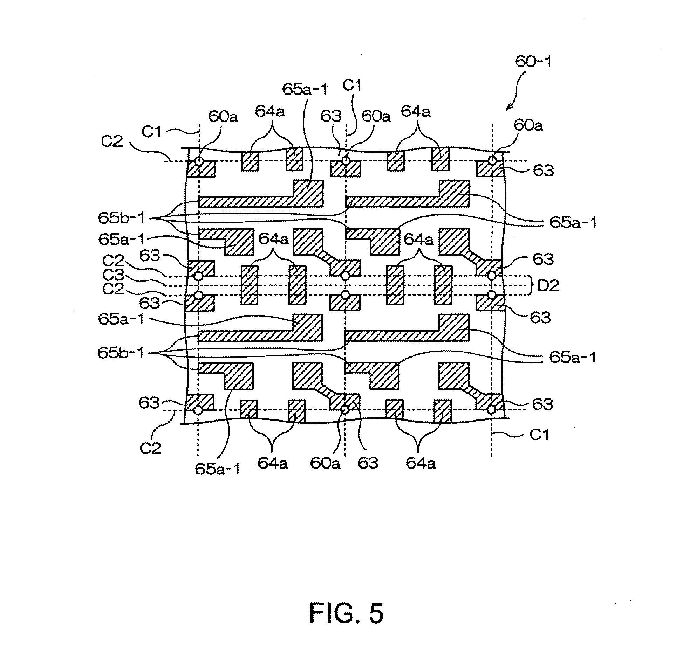

As the substrate, a plate substrate 60-1 large enough to place a plurality of piezoelectric resonators on it is provided as Fig. 5 shows, with an electrode pattern corresponding to a plurality of piezoelectric resonators to be mounted on the substrate 60-1 (Step 1-1 for providing the substrate).

Specifically, an insulating material, such as ceramic or epoxy resin, is molded to have an area on which a plurality of piezoelectric resonators can be fixed. A through-hole 60a including a penetrating, cylindrical via hole is provided at each intersection of vertical cutting lines C1 and horizontal cutting lines C2 for cutting into pieces corresponding to individual piezoelectric oscillators in the following Steps 6 and 8.

The substrate 60-1 includes an area corresponding to the substrate 60 that has been completed (as shown in Fig. 1) and a cutout area D2 in between one substrate 60 and another adjacent substrate 60 that have been completed, and on the side on which the controlling terminal portions 64 are provided. The cutout area D2 is cut away when completing the substrate 60. The cutout area D2, which will be described in greater detail later, is an area to have an electrode coupled to another electrode corresponding to each controlling terminal portion 64 that has been completed, and thereby enabling writing data in the IC chip even after the structure is resin-sealed.

An electrode pattern is then metallized printed, for example, on the substrate 60-1 in a way that the plurality of piezoelectric resonators correspond to the positions on which they are mounted.

Specifically, on the bottom (opposite to the surface shown in Fig. 5) of the substrate 60-1, an electrode pattern (not shown) corresponding to the mounting terminal portion 62 (shown in Fig. 1) that has been completed is provided along the arc of each through-hole 60a on the periphery of each through-hole 60a, with the exception of the cutout area D2. On the upper surface (shown in Fig. 5) of the substrate 60-1, electrode patterns 63 corresponding to the conductive terminal portions 63a, 63b, 63c, 63d that have been completed are provided along the arc of each through-hole 60a on the periphery of each through-hole 60a, with the exception of the cutout area D2.

Here, a conductive pattern on the surface of the castellations 61 shown in Fig. 1 is formed to couple the electrode pattern (not shown) on the periphery of each through-hole 60a on the bottom of the substrate 60-1 and each electrode pattern 63 on the upper surface of the substrate 60-1. This conductive pattern is formed, for example, by applying a conductive paste to fill the opening of the through-hole 60a and then suctioning the through-hole from the bottom side of the substrate so as to apply the paste to the inner wall of the through-hole 60a and dry the paste.

On the upper surface of the substrate 60-1, electrode patterns 64a traversing the cutout area D2 are provided in areas other than where piezoelectric resonators are mounted. The electrode patterns 64a are completed to be the controlling terminal portions 64, except for the parts corresponding to the cutout area D2.

When a plurality of piezoelectric resonators are mounted on the upper surface of the substrate 60-1, electrode patterns 65a-1 are provided so as to face external terminal portions (the terminals 42, 43 shown in Fig. 1) of the plurality of piezoelectric resonators. Also, electrode patterns 65b-1 are provided, extending out from the electrode patterns 65a-1 to portions other than the ones in which the piezoelectric resonators are mounted. The electrode patterns 65a-1 and 65b-1 are completed to be the coupling terminal portions 65.

Then the plurality of piezoelectric resonators undergo the following process.

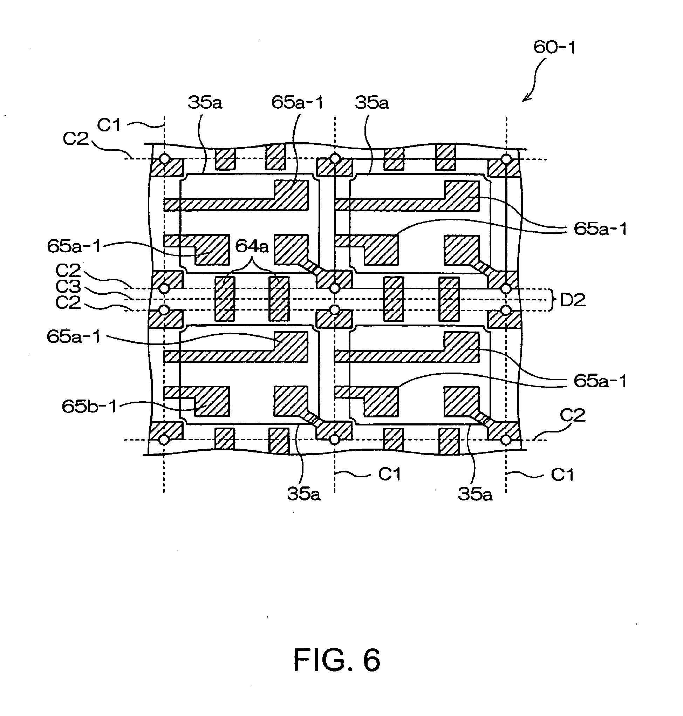

As Fig. 6 shows, a plurality of generic piezoelectric resonators 35a that have been provided in Step 1-2 are coupled on the upper surface of the substrate 60-1. Fig. 6 shows the outline only of each piezoelectric resonator 35a for easy understanding. Specifically, the external terminal portions (the terminals 42, 43 shown in Fig. 1) of the plurality of piezoelectric resonators 35a are coupled to so as to face the electrode patterns 65a-1 provided on the upper surface of the substrate 60-1 (Step 2 for mounting).

The IC chip that has been provided in Step 1-3 is fixed to the upper surface of the lid (the lid 32 shown in Figs. 1 and 3) of each piezoelectric resonator 35a with an epoxy or silicone adhesive (Step 3 for fixing the element). Then step a plurality of IC chips and the plurality of electrode patterns 65b-1, 64a, 63 on the substrate 60-1 are wire-bonded with gold wires, for example, as shown in Fig. 3 (Step 4 for bonding).

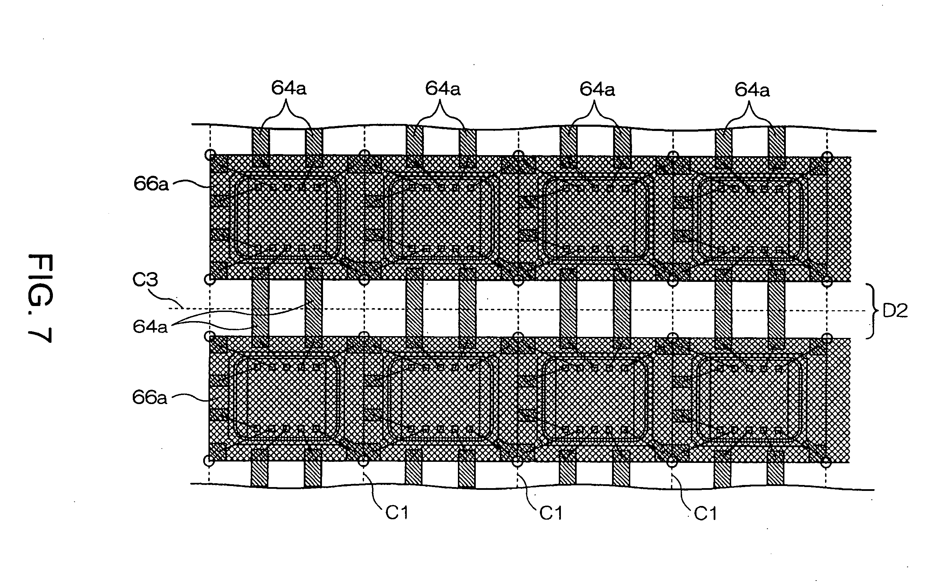

As shown in Fig. 7, the whole structure is sealed by injecting synthetic resin 66a of epoxy, for example, in a mold in order to protect the bonding wires or the like, and insulate between the electrode patterns or the like (Step 5 for sealing). In this sealing step, the resin 66a is not applied to the cutout area D2 provided between one substrate 60 (shown in Fig. 1) and another adjacent substrate 60 that have been completed. Also, at least the electrode patterns that are completed to be mounting terminal portions must be left unsealed by the resin 66a. As long as individual parts are protected and insulated, the whole bottom surface of the substrate 60-1 may be exposed externally as in the present embodiment, for example.

Subsequently, each electrode pattern 64a traversing the cutout area D2 provided between one substrate 60 (shown in Fig. 1) and another adjacent substrate 60 is cut together with the substrate 60-1 along the cutting line C3 shown in Fig. 7. Here, the substrate 60-1 is cut along the vertical cutting lines C1 into individual piezoelectric oscillators (Step 6).

Then a probe is put on the electrode pattern 64a that is not resin-sealed and is exposed externally to write data for temperature compensation in the IC chips so as to provide temperature compensation depending on characteristics of the piezoelectric resonators (Step 7). Since the characteristics differ from one piezoelectric resonator to another, the data for temperature compensation are different for each piezoelectric resonator that has been manufactured. Here, since the substrate 60-1 has been cut into individual pieces in Step 6, it is possible to provide temperature compensation depending on characteristics of each piezoelectric resonator.

Subsequently, the substrate 60-1 is cut along the horizontal cutting lines C2 shown in Fig. 6 into individual piezoelectric oscillators (Step 8), which is followed by a completion test.

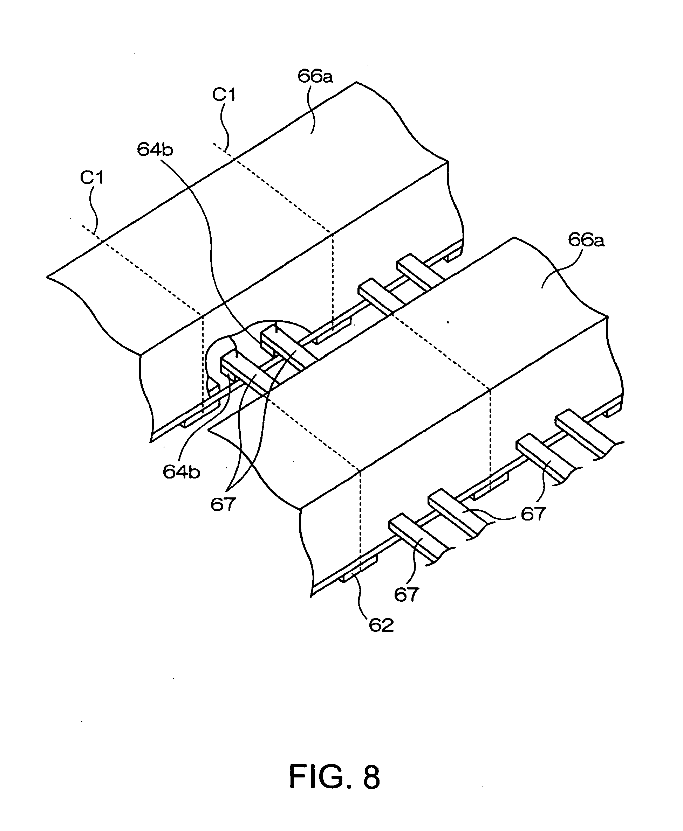

The manufacturing method shown in Figs. 4 through 7 provides the piezoelectric oscillator 30 with one substrate 60-1 large enough to place a plurality of piezoelectric resonators each corresponding to the piezoelectric resonator 35 lengthwise and crosswise on it. Alternatively, a substrate as large as piezoelectric oscillators arranged in a row as shown in Fig. 8 may be used, for example, to manufacture a large number of piezoelectric oscillators as the manufacturing method shown in Figs. 4 and 7 does. In this case, each of a plurality of electrode patterns 64b corresponding to each controlling terminal portion 64 that has been completed is coupled to one end of a lead frame 67. The other end of the lead frame 67 is coupled to another electrode pattern 64b arranged in a row on the substrate.

Also, since the manufacturing method shown in Figs. 4 through 7 requires putting a probe in writing data for temperature compensation, for example, in the electrode pattern 64a, it is necessary to use a resin mold having a concavo-convex surface to mold resin so as not to apply the resin 66a on the cutout area D2 shown in Fig. 7. The following manufacturing method allows a simple resin mold to replace this resin mold with a complex structure.

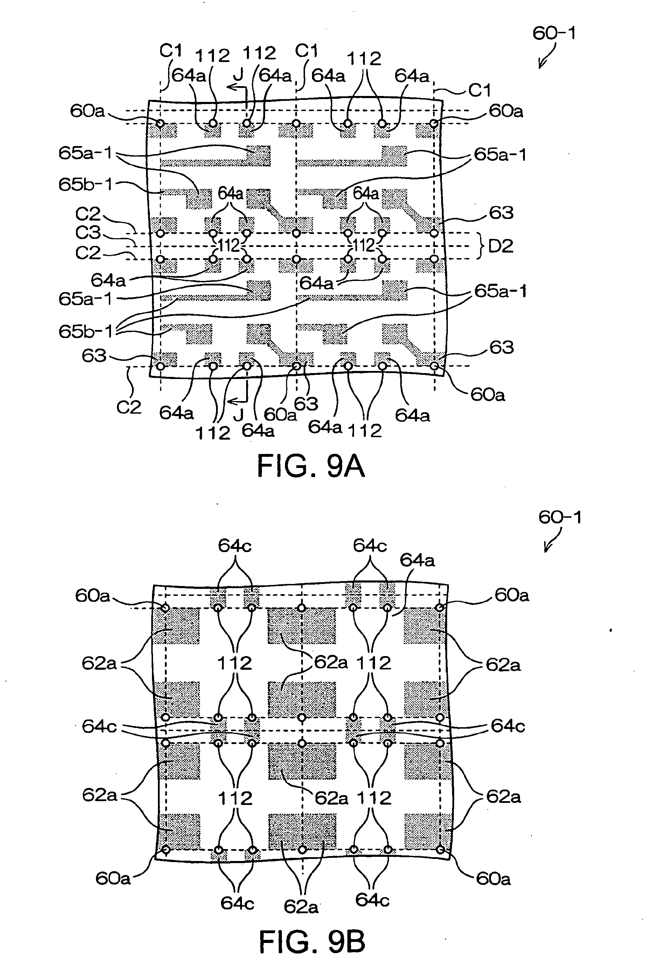

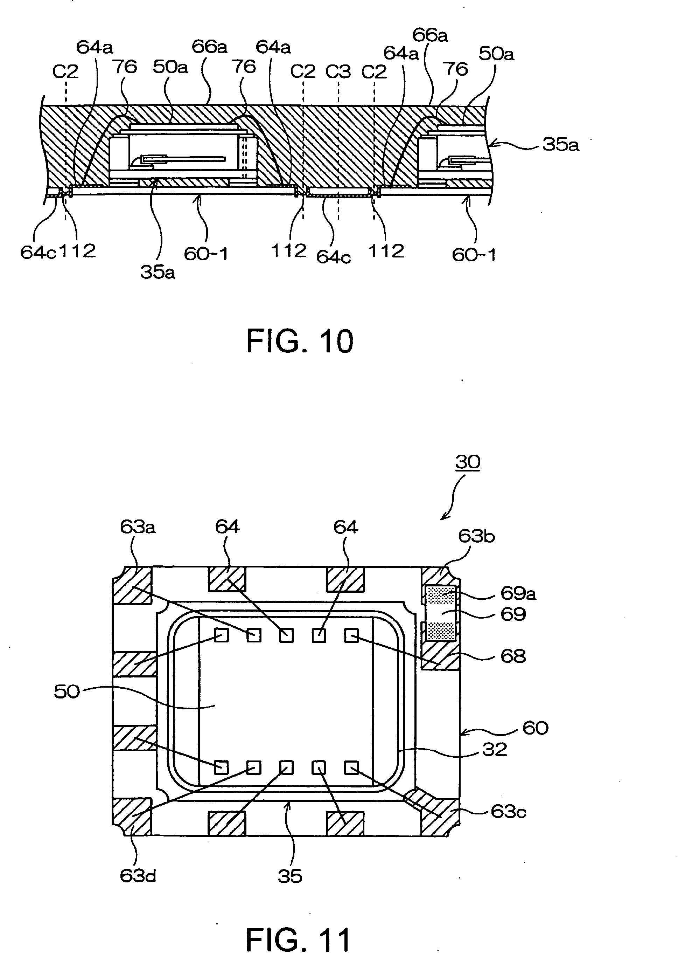

Fig. 9A is a plan view showing the substrate 60-1 viewed from one side on which a piezoelectric resonator, an IC chip, etc., are mounted. Fig. 9B is a plan view showing the substrate 60-1 viewed from another side to which a mounting terminal is provided. Fig. 10 is a section view of the substrate 60-1 shown in Fig. 9, having the IC-chip-mounted piezoelectric resonator that has been resin-molded, along line J-J of Fig. 9.

As shown in Fig. 9A, each electrode pattern 64a on the side of the substrate 60-1 to be resin-molded is not provided in the cutout area D2. Each electrode pattern 64a is electrically coupled to an electrode pattern 64c provided on the mounting side shown in Fig. 9B via a through-hole 112. Each electrode pattern 64c is provided in the cutout area D2 and not laid out in an area 62a serving as a mounting terminal after cutting into individual pieces (after completed).

The piezoelectric resonator 35a on which the IC chip 50a has been mounted is laid out on the substrate 60-1 as shown in Fig. 10, and each IC chip 50a is electrically connected to a corresponding electrode pattern 64a with a bonding wire 76. After the resin 66a is provided to the substrate 60-1, the substrate is cut into individual pieces along the cutting lines C1 and C3 shown in Figs. 9 and 10. In each individual piezoelectric oscillator having a cutout area, as Fig. 10 shows, the electrode pattern 64c used for writing data for temperature compensation, for example, is exposed to the outside of the mounting side of the cutout area D2. Then a probe or the like is put on the electrode pattern 64c exposed externally so as to write data for temperature compensation, for example. Subsequently, the substrate is cut along each cutting line C2, and then tested to complete the piezoelectric oscillator.

This manufacturing method enables writing data for temperature compensation, for example, even if the whole surface of the substrate 60-1 on which a piezoelectric resonator is mounted is resin-molded, since the electrode pattern 64a that has been resin-sealed is coupled to the electrode pattern 64c exposed to the outside of the mounting side through the through-hole 112. Therefore, the piezoelectric oscillator can be manufactured without using a resin mold with a complex structure. In addition, since the electrode pattern 64c used only during this manufacturing process is provided to the cutout area D2, it is possible to write data even if the mounting side of the piezoelectric oscillator is too small to accommodate an electrode pattern. This electrode pattern 64c is removed and does not remain after completion. Thus, there is no possibility of causing a short circuit with a mounting terminal because of mounting solder, for example, while mounting the piezoelectric oscillator on a mounting substrate.

The piezoelectric oscillator 30 according to the first embodiment of the invention has the above-mentioned structure. The IC chip 50 is not housed together with the piezoelectric resonator element 37 in the inner space S1 of a package, but is mounted on the upper surface of the lid 32 of the piezoelectric resonator 35. Accordingly, it is easy to manufacture them in small scale, and operations of the IC chip 50 give no thermal influence on the piezoelectric resonator element 37.

The piezoelectric resonator 35 is fixed on the upper surface of the substrate 60 having the coupling terminal portion 65 corresponding to its external terminal portions 42, 43, and the coupling terminal portion 65 and the IC chip 50 are wire-bonded. Therefore, it is possible to couple the piezoelectric resonator 35 and the IC chip 50 without laying out an electrode inside the package 36. The substrate 60 has the mounting terminal portion 62 on its bottom, and the conductive terminal portions 63b, 63d electrically coupled to the mounting terminal portion 62 on its upper surface. The conductive terminal portions 63b, 63d and the IC chip 50 are wire-bonded, and thereby the mounting terminal portion 62 and the IC chip 50 are electrically coupled to each other. Accordingly, by using the piezoelectric resonator 35 as a generic part, a piezoelectric oscillator having the mounting terminal portion 62, the IC chip 50, and the piezoelectric resonator 35 that are electrically coupled to each other is provided.

While one IC chip 50 is fixed on the upper surface of the piezoelectric resonator 35 referring to Figs. 1 and 7, other electronic parts such as a capacitor than the IC chip 50 can be used if necessary. In this case, a terminal portion 68 electrically coupled to the IC chip 50 with wire bonding may be provided on the surface of the substrate 60 as shown in Fig. 11 showing a view through the resin. Accordingly, coupling the terminal portion 68 to an electronic part 69 provides electrical coupling between the electronic part 69 and the IC chip 50, even if the electronic part 69 cannot be fixed on the upper surface of the lid 32 of the piezoelectric resonator 35. Here, the terminal portion 68 shown in Fig. 11 is arranged to couple a terminal 69a of the electronic part 69 to the conductive terminal portion 63d.

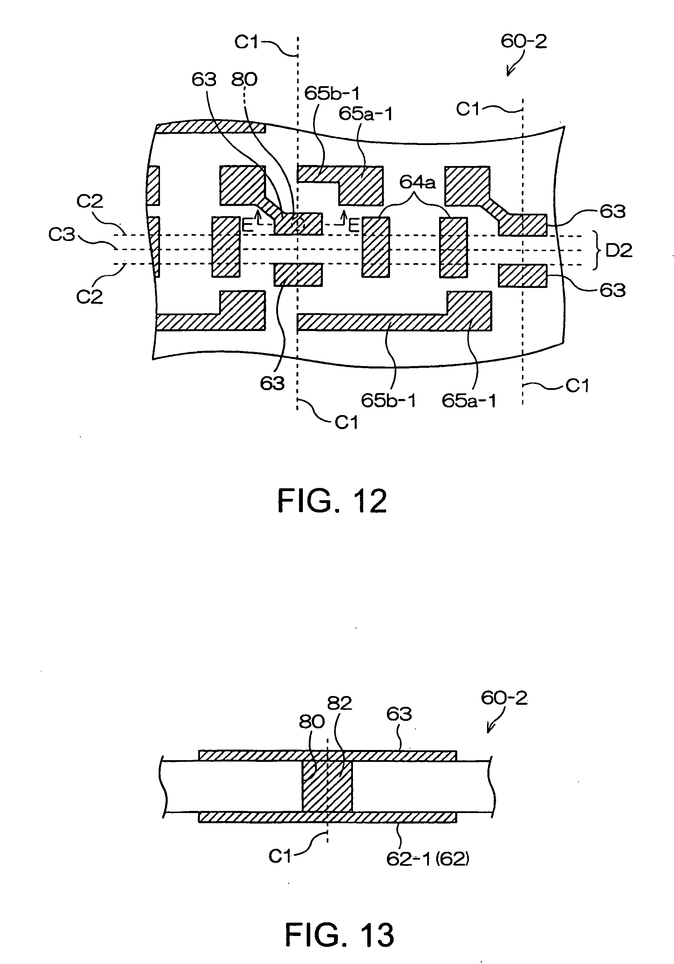

Figs. 12 and 13 show a first modification of the piezoelectric oscillator according to the first embodiment of the invention. Specifically, Fig. 12 shows a modification of the substrate described in the method for manufacturing the piezoelectric oscillator referring to Fig. 5, and Fig. 13 is a sectional view along line E-E of Fig. 12.

The parts shown in these view that are common to the piezoelectric oscillator 30 shown in Fig. 1 through 11 are given like reference numerals, and the description thereof will be omitted here.

This modification of the piezoelectric oscillator according to the first embodiment differs from that of the first embodiment mainly in the way to electrically couple the mounting terminal portion 62 and the electrode patterns 63a, 63d that have been completed in the step for providing the substrate.

According to this modification, a plate substrate 60-2 to place a plurality of piezoelectric resonators is provided, and a through-hole 80 having a circular cross section is provided to the substrate 60-2 in the step for providing the substrate (Step 1-1 shown in Fig. 4). The through-hole 80 is for electrically coupling the mounting terminal portion 62 and the conductive terminal portions 63a, 63d that have been completed.

Specifically, the through-hole 80 is provided in areas in which the electrode pattern 63 corresponding to the conductive terminal portions 63a, 63d that have been completed (see Fig. 1) and an electrode pattern 62-1 corresponding to the mounting terminal portion 62 that has been completed (see Fig. 1) are provided, traversing the cutting lines C1 for cutting into individual piezoelectric oscillators.

The through-hole 80 is filled with a conductive member 82. The conductive member 82 can be of any type as long as it electrically couples the mounting terminal portion 62 and the conductive terminal portions 63a, 63d that have been completed and fills the through-hole 80. Taking bonding strength with the package 36 into consideration, tungsten (W) metallized and plated thereon with nickel (Ni) and gold (Au) is used here to fill the through-hole 80.

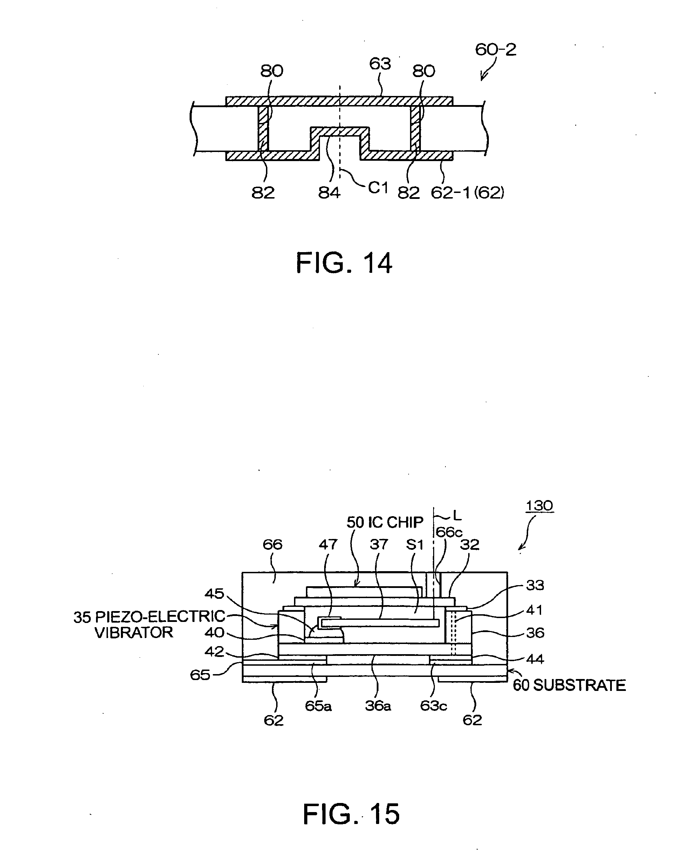

More preferably, the through-hole 80 is provided not on, but off the cutting lines C1 for cutting into individual piezoelectric oscillators as shown in Fig. 14, a modification of Fig. 13. Then, a bottomed hole is formed in part of the mounting terminal portion 62 that has been completed (see Fig. 1). Specifically, a bottomed hole 84 is provided in areas in which each electrode pattern 62-1 on the bottom is laid out, and on the cutting lines C1 for cutting into individual piezoelectric oscillators. Inside the bottomed hole 84, an electrode integrally formed with the electrode pattern 62-1 is provided.

The first modification of the first embodiment has the above-described structure, and provides the same effects as the first embodiment does.

The through-hole 80 for electrically coupling the mounting terminal portion 62 and the conductive terminal portions 63a, 63d that have been completed is filled with and blocked up by the conductive member 82. Accordingly, when resin is injected in a mold cavity, for example, in the sealing step (Step 5 shown in Fig. 4) following the step for providing the substrate, it is possible to prevent the resin from passing through the through-hole 80 and flowing out from the upper side to the bottom side.

More preferably, not the through-hole 80 but the bottomed hole 84 is provided on the cutting lines C1 in Fig. 14. Accordingly, the bottomed hole is formed in part of each mounting terminal 62 in a single manufacturing process. When mounting the piezoelectric oscillator, solder or the like for coupling a mounting substrate and the mounting terminal 62 is attached inside the bottomed hole to form a fillet and increase bonding strength.

Fig. 15 is a sectional view schematically showing a piezoelectric oscillator 130 according to a second modification of the first embodiment of the invention.

The parts shown in this view that are common to the piezoelectric oscillator 30 shown in Fig. 1 through 14 are given like reference numerals, and the description thereof will be omitted here.

The piezoelectric oscillator 130 according to the second modification of the first embodiment differs from that of the first embodiment mainly in that the resin has a hole for adjusting frequencies.

The lid 32 made of a material, such as translucent glass, is bonded to the opening end of the package 36 of the piezoelectric resonator 35 with a solder material 33 such as low-melting glass therebetween.

The resin 66 is provided with a linear through-hole 66c through which the surface of the lid 32 communicates with the outside. Note that the IC chip 50 is laid out so as not to block up the through-hole 66c.

The second modification of the first embodiment has the above-described structure, and provides the same effects as the first embodiment does. Furthermore, an excitation electrode, plummet, etc., (not shown) on the piezoelectric resonator element 37 is irradiated with laser light L via the through-hole 66c after resin-molded. Therefore, even if the piezoelectric resonator element 37 is under heat or other stress while being manufactured, frequencies can be accurately adjusted by mass-relieving.

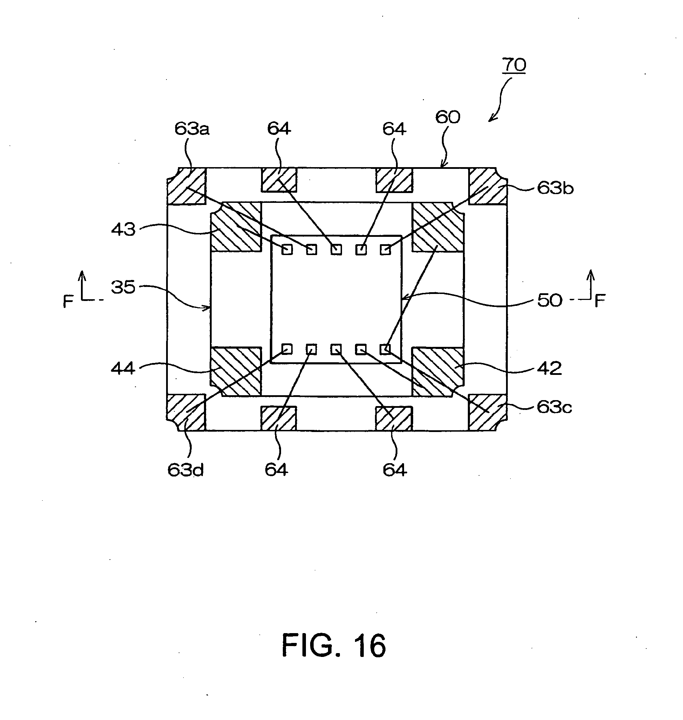

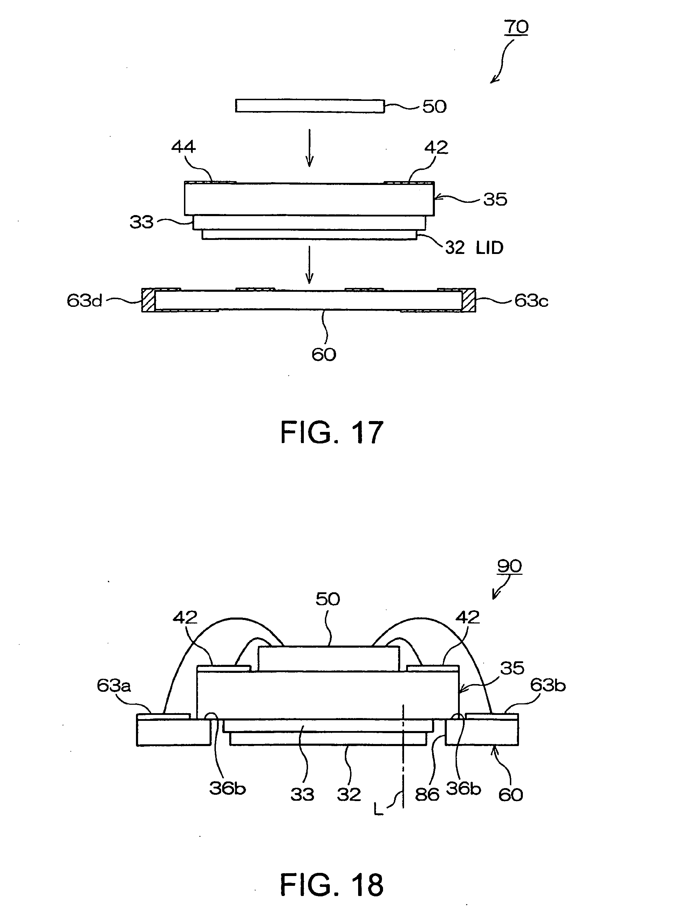

Figs. 16 and 17 show a second embodiment of a piezoelectric oscillator according to the invention. Fig. 16 is a schematic plan view, while Fig. 17 is an exploded view. Figs. 16 and 17 do not show the resin 66 also used in the first embodiment shown in Fig. 3 for easy understanding.

The parts shown in these drawings that are common to the piezoelectric oscillator 30 or 130 shown in Fig. 1 through 15 are given like reference numerals, and the description thereof will be omitted here.

A piezoelectric oscillator 70 according to the second embodiment differs from that of the first embodiment mainly in that the piezoelectric resonator 35 is fixed upside down on the substrate 60.

While a generic product is used as the piezoelectric resonator 35 like in the first embodiment, the piezoelectric resonator 35 is fixed on the upper surface of the substrate 60 in a way that the lid 32 faces the substrate as Fig. 17 shows.

By coupling the lid 32 side to the substrate 60, another side having the external terminal portions 42, 43 faces upward. On the side having the external terminal portions 42, 43, the IC chip 50 is fixed.

Fixing the IC chip 50 is on the side having the external terminal portions 42, 43 allows the external terminal portions 42, 43 and the IC chip 50 to be wire-bonded on the same side of the piezoelectric resonator 35.

The second embodiment of the invention has the above-described structure, and provides the same effects as the first embodiment does. Furthermore, the external terminal portions 42, 43 and the IC chip 50 can be directly wire-bonded without providing the coupling terminal portion 65 on the substrate 60 as in the first embodiment. Also, providing the external terminal portions 42, 43 and the IC chip 50 on the same side of the piezoelectric resonator 35 makes it possible to shorten a distance between the external terminal portions 42, 43 and the IC chip 50 and thus shorten a bonding wire than in the first embodiment, reducing stray capacitance.

Fig. 18 is a sectional view schematically showing a first modification of the second embodiment, along line F-F of Fig. 16.

The parts shown in this drawing that are common to the piezoelectric oscillator 30, 70 or 130 shown in Fig. 1 through 17 are given like reference numerals, and the description thereof will be omitted here.

Referring to Fig. 18, a piezoelectric oscillator 90 according to the first modification of the second embodiment differs from that of the second embodiment mainly in that the substrate 60 has a hole 86 in an area facing the lid 32.

Specifically, the lid 32 is not bonded to the periphery of an opening end 36b of the package 36, but is bonded in a way that a step is formed on the opening end 36b side in the piezoelectric resonator 35 as shown in Fig. 18. Here, the substrate 60 is almost as thick as or thicker than the lid 32 and the solder material 33.

Referring to Fig. 18, the substrate 60 has the hole 86 including a through-hole penetrating in the thickness direction in an area facing the lid 32. The lid 32 is inserted in the hole 86 in a way that the vicinity of the hole 86 and the periphery of the opening end 36b of the package 36 are bonded.

The first modification of the second embodiment has the above-described structure, in which the lid 32 is inserted in the hole 86 of the substrate 60. Therefore, it is possible to reduce the height of the piezoelectric oscillator 90 by the thickness to which the lid 32 is inserted. The hole 86 also serves as a guide for mounting the piezoelectric resonator 35 on the substrate 60.

Also according to the first modification of the second embodiment, since the lid 32 is exposed externally, as shown in Fig. 18, it is possible to irradiate the product structure from its bottom with laser light L, penetrating the lid 32 made of light-transmitting glass or other materials so as to adjust frequencies by mass-relieving. Therefore, there is no need to provide the through-hole 66c to the resin 66 unlike the second modification of the first embodiment shown in Fig. 15.

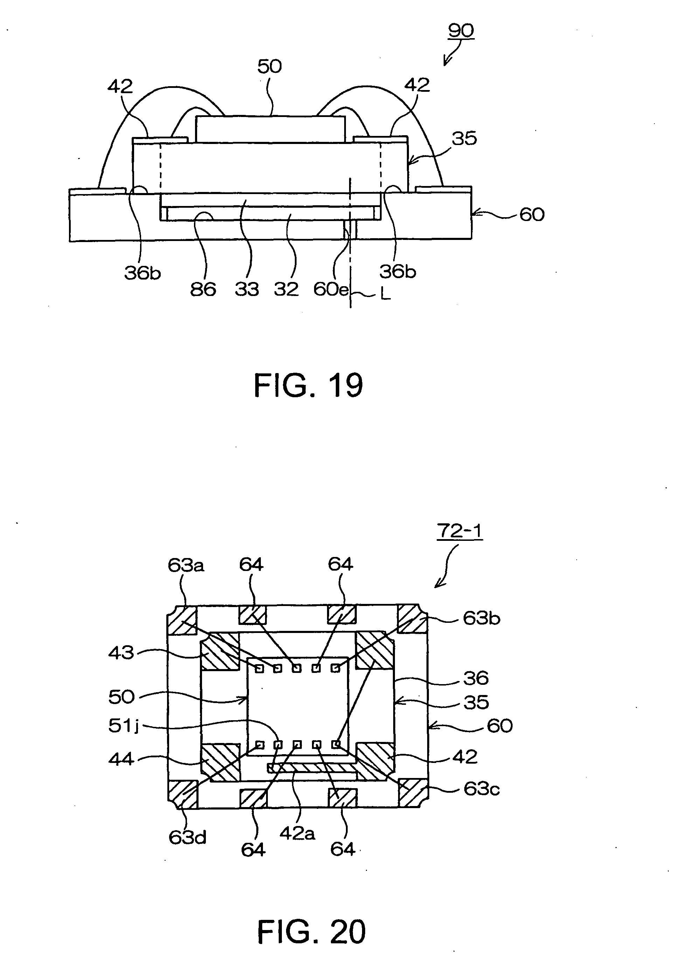

While the hole 86 is a through-hole in Fig. 18, a bottomed hole can also reduce the height compared to the structure having no such hole, and serve as a guide for mounting the piezoelectric resonator 35 as shown in Fig. 19, a modification of Fig. 18. For example, if bonding the lid 32 to the periphery of the opening end 36b of the package 60 hampers bonding between the periphery of the opening end 36b and the substrate 60, that is, when the side wall of the package is on the dotted line of Fig. 19, the bottom of the hole 86 and the piezoelectric resonator 35 can be bonded.

Also, when the hole 86 of the substrate 60 is the bottomed hole, a linear through-hole 60e through which the surface of the lid 32 communicates with the outside is provided to the substrate 60. An excitation electrode, plummet, etc., (not shown) on the piezoelectric resonator element may be irradiated with laser light L via the through-hole 60e to adjust frequencies.

Figs. 20 through 22 are plan views schematically showing a second modification of the second embodiment of the invention and third and fourth exemplary modifications, respectively.

The parts shown in these drawings that are common to the piezoelectric oscillator 30, 70, 90 or 130 shown in Fig. 1 through 19 are given like reference numerals, and the description thereof will be omitted here.

Referring to Figs. 20 through 22, piezoelectric oscillators according to the second through fourth modifications differ from that of the second embodiment mainly in that the surface of the piezoelectric resonator has an electrode pattern other than the external terminal portion, and wire-bonding is provided through the electrode pattern.

The piezoelectric resonator 35 shown in Figs. 20 through 22 is provided with an electrode pattern between the terminal portions of the IC chip 50 and the external terminal portions 42, 43 to be electrically coupled to the terminal portions, and/or each terminal 63a through 63d, 64 on the substrate.

Specifically, a piezoelectric oscillator 72-1 according to the second modification shown in Fig. 20 has, on the surface of the piezoelectric resonator 35 having the external terminal portions 42, 43, an extended portion 42a coupled to the external terminal portion 42 and extending out to the vicinity of the terminal portion 51j of the IC chip 50 to be electrically coupled to the external terminal portion 42.

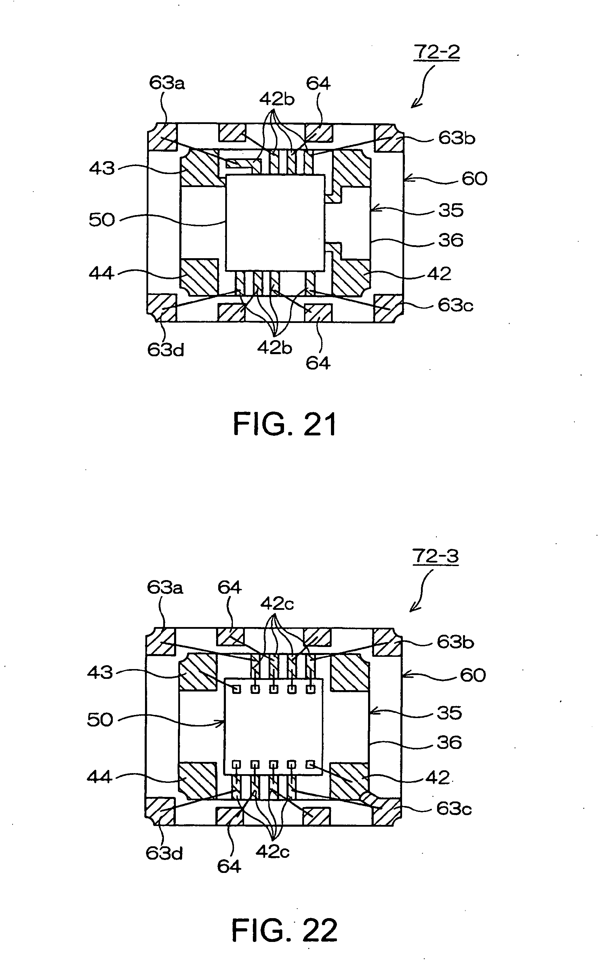

A piezoelectric oscillator 72-2 according to the third exemplary modification shown in Fig. 21 has, on the surface of the piezoelectric resonator 35 having the external terminal portions 42, 43, a plurality of electrode patterns 42b corresponding to the position and number of terminal portions (not shown) of the IC chip 50. The terminal portions of the IC chip 50 are flip-chip bonded on the plurality of electrode patterns 42b. Each of the electrode patterns 42b is laid out from the terminal portions of the IC chip 50 toward each terminal on the substrate 60 to be electrically coupled to the terminal portions.

A piezoelectric oscillator 72-3 according to the fourth exemplary modification shown in Fig. 22 has, on the surface of the piezoelectric resonator 35 having the external terminal portions 42, 43, a plurality of electrode patterns 42c. Each of the electrode patterns 42c is wire-bonded to each one terminal portion of the IC chip 50, and also to each terminal on the substrate 60 to be electrically coupled to the terminal portion of the IC chip 50.

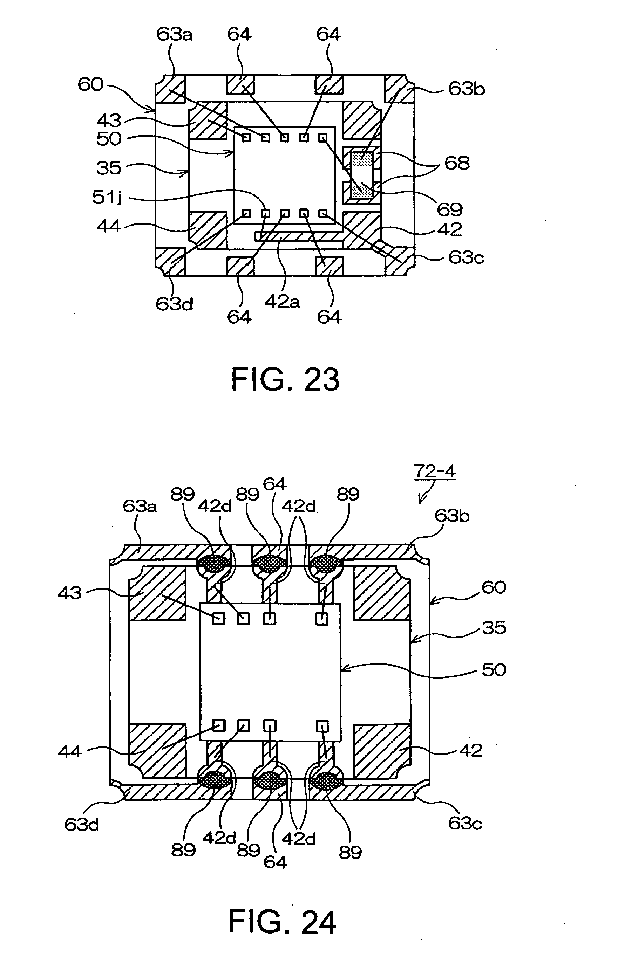

While one IC chip 50 is fixed on the piezoelectric resonator 35 in the piezoelectric oscillators 72-1, 72-2, 72-3 referring to Figs. 20 through 22, other electronic parts such as a capacitor than the IC chip 50 can be used if necessary. In this case, terminal portions 68 electrically coupled to the IC chip 50 with wire bonding may be provided on the surface of the piezoelectric resonator 35 as shown in Fig. 23, a modification of the piezoelectric oscillator 72-1 shown in Fig. 20, for example. Accordingly, coupling the terminal portions 68 to the electronic part 69 provides electrical coupling between the electronic part 69 and the IC chip 50. Referring to Fig. 23, one of the terminal portions 68 is electrically coupled to the conductive terminal portion 63 with wire bonding.

Furthermore, by thickly plating the electrode patterns 42a, 42b, 42c or the terminals 42, 43, 44, etc. shown in Fig. 20, 21 or 22, even if a paste adhesive flows out in bonding the IC chip 50 to the piezoelectric resonator 35, it is possible to prevent the adhesive from attaching to the surface of these electrodes or terminals. In this case, the flow of the adhesive can be restricted by forming a convex portion by screen printing, for example, in addition to or instead of the above-described processing of the electrode patterns 42a, 42b, 42c, etc.

The second modification of the second embodiment of the invention and the third and fourth modifications have the above-mentioned structures, which provide easy wire bonding using the electrode patterns 42a, 42b, 42c, which are provided on the surface of the piezoelectric resonator 35 in addition to the external terminal portions 42, 43, even if wire bonding is difficult to lay out due to the terminal-portion configuration of the IC chip 50 that is commercially available, for example.

The electrode patterns 42a, 42b, 42c are provided to the piezoelectric resonator 35 itself in the modifications, and thereby the complete piezoelectric resonator is not generic in the strict sense. However, since the electrode patterns 42a, 42b, 42c are provided to the surface of the piezoelectric resonator 35, it is possible to provide the electrode patterns 42a, 42b, 42c afterwards to the surface of the piezoelectric resonator 35 that is generic. Even without providing the electrode patterns 42a, 42b, 42c afterwards to the surface of the piezoelectric resonator 35 that is generic, the electrode patterns 42a, 42b, 42c are not laid out inside the package 36 as they are in related art structures. Therefore, manufacturing costs can be reduced compared to related art structures and smaller packaging can be achieved, and thereby providing the same effects as the second embodiment does.

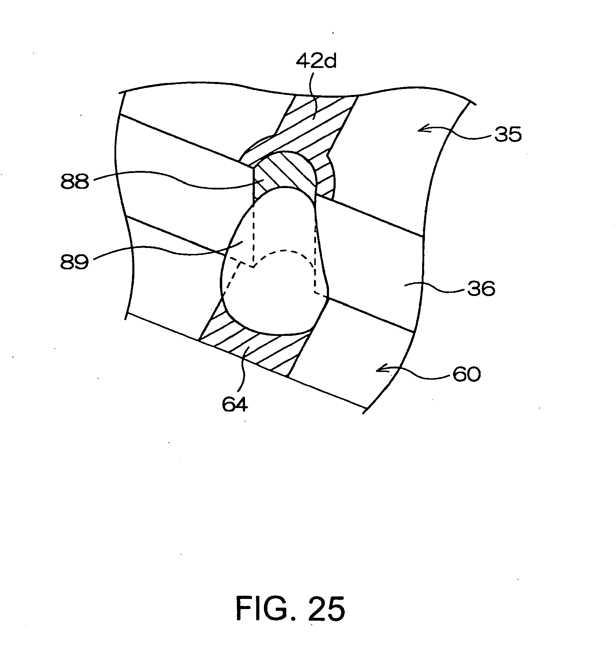

Figs. 24 and 25 show yet another exemplary modification of the fourth exemplary modification. Specifically, Fig. 24 is a schematic plan view, and Fig. 25 is a perspective view partially enlarging a feature in Fig. 24.

The parts shown in these drawings that are common to the piezoelectric oscillator 30, 70, 90, 72-3 or 130 shown in Fig. 1 through 23 are given like reference numerals, and the description thereof will be omitted here.

Referring to Figs. 24 and 25, a piezoelectric oscillator 72-4 differs from that of the fourth exemplary modification mainly in coupling between electrode patterns provided on the surface of the piezoelectric resonator 35 and terminals on the upper surface of the substrate.

In the piezoelectric oscillator 72-4, electrode patterns 42d are electrically coupled through a conductive body 88 to the terminals 63a through 63d, 64 provided in the vicinity of the rim of the substrate.

Specifically, in the same manner as the piezoelectric oscillator 72-3 shown in Fig. 22, the plurality of electrode patterns 42d are provided between terminal portions of the IC chip 50 and each of the terminals 63a through 63d, 64 to be electrically coupled to the terminal portions. The plurality of electrode patterns 42d and the terminal portions of the IC chip 50 are wire-bonded.

As shown in Fig. 25, the piezoelectric oscillator 72-4 has the conductive body 88 along the thickness direction on the inner surface of a concave, quarter-circle castellation provided to the side of the piezoelectric resonator 35. Each electrode pattern 42d is electrically coupled to this conductive body 88.

The substrate 60 is arranged to align the conductive terminal portions 63a through 63d and the controlling terminal portions 64 to each corresponding conductive body 88. The conductive terminal portions 63a through 63d, the controlling terminal portions 64, and each corresponding conductive body 88 are coupled with a conductive adhesive or solder 89, for example.

The modification of the fourth exemplary modification has the above-described structure. Wire-bonding between each electrode pattern 42d to a corresponding terminal portion of the IC chip 50 provides electrical coupling between the terminal portions of the IC chip 50 and the terminals 63a through 63d, 64 on the substrate, with each electrode patterns 42d and conductive body 88 therebetween. Accordingly, a space for laying out bonding wires is no more required between the piezoelectric resonator 35 and the substrate 60, thereby reducing the size of the piezoelectric oscillator 72-4.

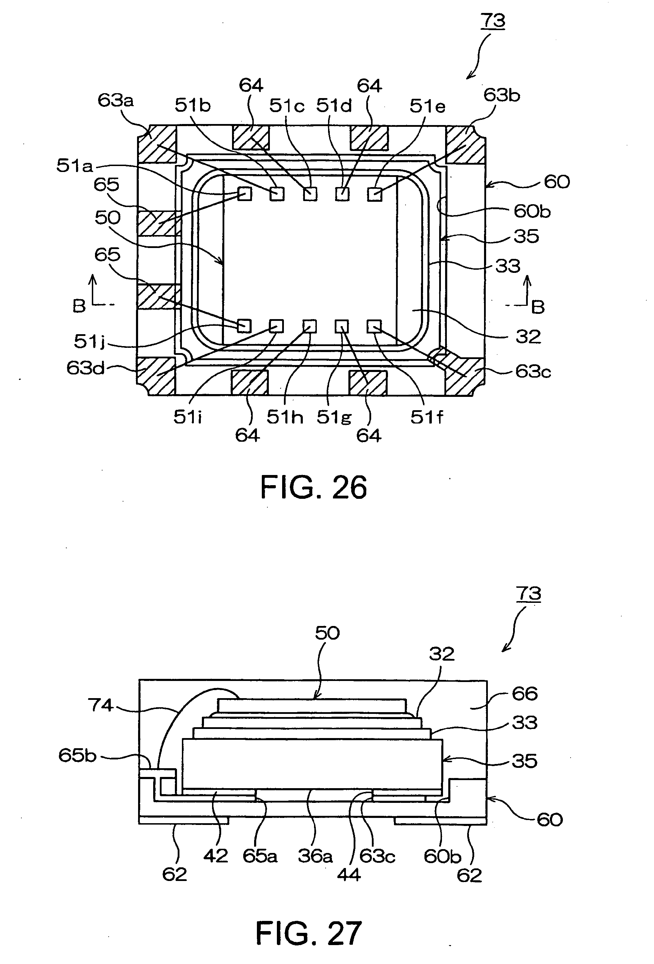

Figs. 26 and 27 show a piezoelectric oscillator according to a third embodiment of the invention. Fig. 26 is a schematic plan view thereof, while Fig. 27 is a schematic sectional view thereof along line B-B of Fig. 26. For easy understanding, Fig. 26 does not show the resin 66 described in the above embodiments, while Fig. 27 shows part of the bonding wire.

The parts shown in these view that are common to the piezoelectric oscillator 30 shown in Fig. 1 through 7 are given like reference numerals, and the description thereof will be omitted here.

A piezoelectric oscillator 73 according to the third embodiment differs from that of the first embodiment mainly in that the substrate 60 is provided with a concave portion.

The piezoelectric resonator 35 is fixed to a concave 60b of the substrate 60. The periphery of the substrate 60 is raised from the concave 60b, forming a bank.

Provided on the bottom of the concave 60b of the substrate 60, and facing the external terminal portions 42, 43 (shown in Fig. 1), is the part 65a of the coupling terminal portion 65. The part 65a is laid out in the substrate 60 and is coupled to the part 65b of the coupling terminal portion 65 provided on the periphery raised from the concave 60b.

Also provided to the periphery of the substrate 60 raised from the concave 60b are the controlling terminal portion 64 and the conductive terminal portions 63a through 63d.

The third embodiment of the invention has the above-described structure, and provides the same effects as the first embodiment does. Moreover, since the piezoelectric resonator 35 is fixed to the concave 60b of the substrate 60, the concave 60b serves as a guide for easily placing the piezoelectric resonator 35 on the substrate 60.

The part 65b of the coupling terminal portion 65 coupled to a bonding wire 74 is provided on the periphery of the substrate raised from the concave 60b, and the piezoelectric resonator 35 is inserted in the concave 60b area. Accordingly, the part 65b of the coupling terminal portion 65 is placed closer to the IC chip 65 than in the first embodiment. Therefore, the distance for laying down the bonding wire 74 is reduced, making wire bonding easier.

In addition, it is possible to prevent an adhesive to fix the piezoelectric resonator 35 to the substrate 60 from flowing into the part 65b of the coupling terminal portion, the controlling terminal portions 64, and the conductive terminal portions 63a through 63d, and thereby preventing wire-bonding contact failure.

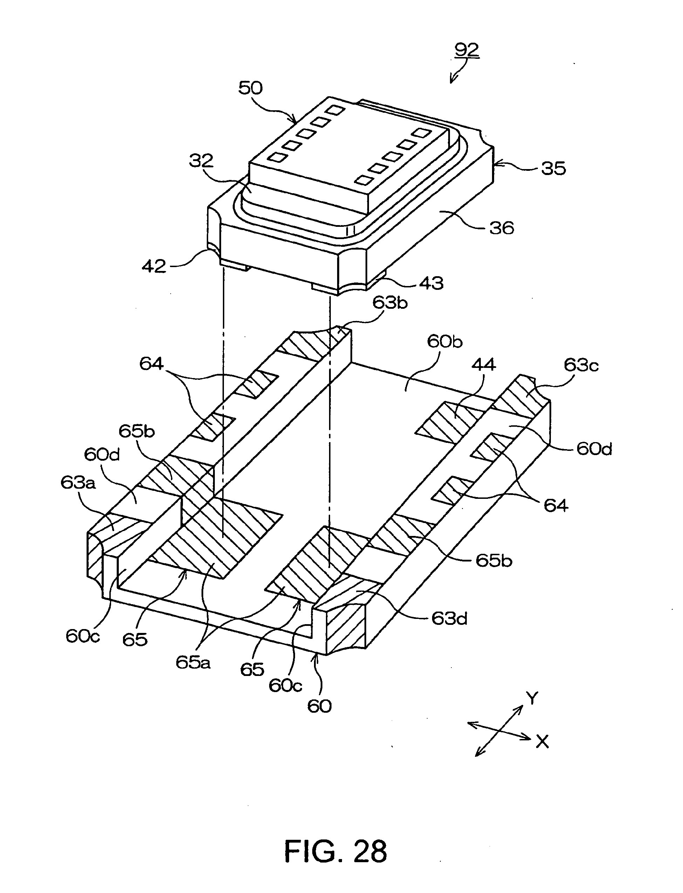

Fig. 28 is an exploded perspective view schematically showing a first modification of the third embodiment of the invention. For easy understanding, this drawing does not show the resin and bonding wire described in the above embodiments.

The parts shown in this drawing that are common to the piezoelectric oscillator 30, 70, 90, 73 or the like shown in Fig. 1 through 27 are given like reference numerals, and the description thereof will be omitted here.

A piezoelectric oscillator 92 according to the first modification of the third embodiment differs from that of the third embodiment mainly in the shape of the concave provided to the substrate 60.

Here, part of the concave 60b has no bank, and has a horizontally open area (in the Y-direction in Fig. 28), instead of being surrounded by walls 60c.

Specifically, the substrate 60 shown in Fig. 28 has the concave 60b at least in its area to which the piezoelectric resonator 35 is fixed. The two sides along the longitudinal direction (in the Y-direction in Fig. 28) of its periphery have banks 60d raised from the bottom of the concave 60b, while the other two sides that are shorter (in the X-direction in Fig. 28) have no banks 60d.

All the terminals to be wire-bonded, that is, the part 65b of the coupling terminal portion 65, the conductive terminal portions 63a, 63b, 63c, 63d, and the controlling terminal portions 64, are placed not on the bottom of the concave 60b, but on the banks 60d.

The part 65a of the coupling terminal portion 65 facing the external terminal portion 42 or 43 is extended out to the walls 60c and electrically coupled to the part 65b provided on the banks 60d. The dummy terminal portion 44 is also extended out to one wall 60c and electrically coupled to the conductive terminal portion 63c provided on one bank 60d.

The first modification of the third embodiment has the above-described structure, and provides the same effects as the third embodiment does. The substrate 60 is provided with the horizontally open area (in the Y-direction in Fig. 28), instead of being surrounded by the wall 60c, which can be utilized for mounting electronic parts. For example, if the piezoelectric resonator 35 is mounted on the substrate with its Y-direction length reduced so that the part 65a of the coupling terminal portion 65 comes close to the rim, the length of the piezoelectric oscillator 92 is reduced in the Y-direction compared to the third embodiment. Also, capacitors and other electronic parts can be mounted on this open area.

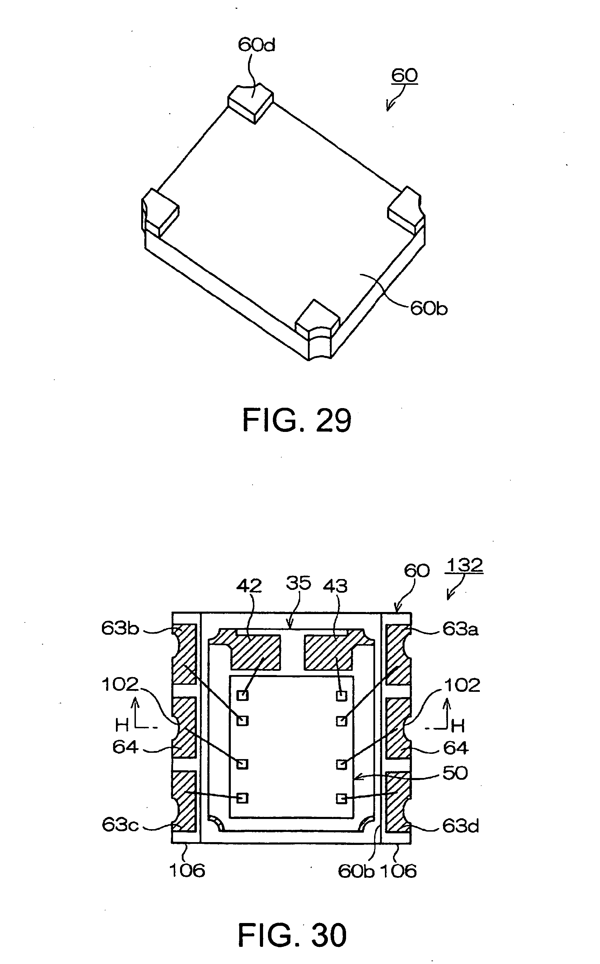

While the substrate has the concave with no bank on two sides in Fig. 28, the modification is not limited to this. As long as the above-described effects are provided, the substrate 60 may have a concave with no bank on two or more sides, for example, as shown in Fig. 29.

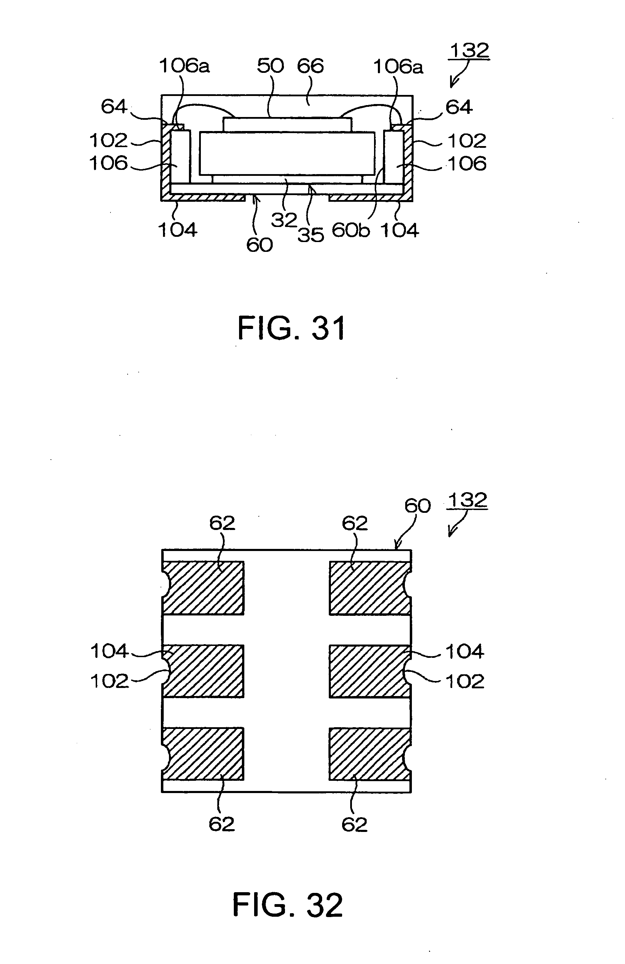

Figs. 30 through 32 show a piezoelectric oscillator 132 according to a second modification of the third embodiment. Fig. 30 is a plan view schematically showing the piezoelectric oscillator 132, Fig. 31 is a sectional view along line H-H of Fig. 30, and Fig. 32 is a bottom view schematically showing the piezoelectric oscillator 132. For easy understanding, these drawings show the resin as if it is transparent, so that the inside can be viewed. Also, they do not show part of the bonding wire described in the above embodiments.

The parts shown in these drawings that are common to the piezoelectric oscillator 30, 70, 73, 90, 92 or the like shown in Fig. 1 through 29 are given like reference numerals, and the description thereof will be omitted here.

The piezoelectric oscillator 132 according to the second modification differs from that of the third embodiment mainly in the arrangement of the piezoelectric resonator 35 and the IC chip 50, and the substrate 60 having walls.

The piezoelectric resonator 35 and the IC chip 50 are arranged in the same manner as in the second embodiment. Specifically, the piezoelectric resonator 35 is fixed on the substrate 60 in a way that the external terminal portions 42, 43 face upward and the lid 32 faces the upper surface of the substrate 60. The IC chip 50 is fixed on the side having the external terminal portions 42, 43.

The substrate 60 is provided with a pair of walls 106 on the both ends of its shorter sides. The piezoelectric resonator 35 is fixed in the resultant concave 60b. The substrate 60 is provided with no bank and has an open area, as in the second modification of the third embodiment, in the direction (the longitudinal direction of Fig. 30) other than the one (the shorter sides of Fig. 30) provided with the pair of walls 106.

Ends 106a of the walls 106 are located at almost the same level in the height direction of Fig. 31 as the terminal portions of the IC chip 50. Specifically, the ends 106a of the walls 106 are located in between the level of the surface having the external terminal portions 42, 43 of the piezoelectric resonator 106 and the level of the surface having the terminal portions of the IC chip 50. Referring to Fig. 31, the ends 106a of the walls 106 are located at the same level as the surface having the external terminal portions 42, 43 of the piezoelectric resonator 106. The ends 106a of the walls 106 in the height direction are provided with the conductive terminal portion 63b and the controlling terminal portions 64, and these terminal portions are wire-bonded to the terminal portions of the IC chip 50 with a gold wire, for example.

In addition, write-in terminals 104 electrically coupled to the controlling terminal portions 64 are provided to the bottom of the substrate 60.

Specifically, only the mounting terminal portions 62 and the write-in terminals 104 are provided to the bottom of the substrate 60. The mounting terminal portions 62 are located substantially at the four corners, while the write-in terminals 104 are substantially at the center portion in the longitudinal direction. The write-in terminals 104 provided to the bottom are coupled to the controlling terminal portions 64 on the ends 106a, through a conductive pattern 102 in a groove along the height direction of the side of the substrate 60 (the sides of the walls 106 and the substrate 60 in Fig. 31).

The second modification of the third embodiment has the above-described structure, and provides the same effects as the third embodiment and its first modification do. The walls 106 have the ends 106a almost as high as the terminal portions of the IC chip 50, and are wire-bonded to the terminal portions of the IC chip 50 with the conductive terminal portion 63b or the like provided to the ends 106a. Accordingly, it is possible to shorten the bonding wire and thus reduce stray capacitance than in the third embodiment and its first modification.

Also, the write-in terminals 104 electrically coupled to the controlling terminal portions 64 can be formed widely on the bottom of the substrate 60, since the substrate has only the mounting terminal portions 62 other than the terminals and thus has a wide blank area. Accordingly, a contact failure of a write-in probe pin can be reduced, and thereby increasing yields.

It should be understood that the present invention is not limited to the above-mentioned embodiments.

## Claims

1. A piezoelectric oscillator (30), in which at least a conductive part except for a mounting terminal portion (62) is sealed with resin (66), comprising:
(a) a substrate (60) whose bottom is provided with the mounting terminal portion (62);
(b) a piezoelectric resonator (35) housing a piezoelectric resonator element (37) in a package (36) fixed on the upper surface of the substrate (60) and sealed with a lid (32), and having an external terminal portion (42) electrically coupled to the piezoelectric resonator element (37) on the surface of the package (36) by means of an electrode portion (40) exposed to an inner space of the package (36) ;
and
(c) an oscillator circuit element (50) included in an oscillator circuit and fixed on a side of the package (36) opposite to the side facing the substrate (60);
(d) the substrate (60) including on its upper surface a conductive terminal portion (63a, 63b, 63c, 63d) electrically coupled to the mounting terminal portion (62), and
(e) the external terminal portion (42) and the conductive terminal portion (63a, 63b, 63c, 63d) being electrically coupled to the oscillator circuit element (50),
wherein
the piezoelectric resonator (35) is fixed to make the external terminal portion face the upper surface of the substrate (60),
the oscillator circuit element (50) is fixed to the upper surface of the lid (32) included in the piezoelectric resonator (35),
the substrate (60) includes a coupling terminal portion (65) provided in an area facing the external terminal portion (42), and
extends from the area to a periphery, and
the coupling terminal portion (65) and the conductive terminal portion (63a, 63b, 63c, 63d) are wire bonded to terminal portions (51a,...51j) of the oscillator circuit element (50).

2. A piezoelectric oscillator (30), in which at least a conductive part except for a mounting terminal portion (62) is sealed with resin (66), comprising:
(a) a substrate (60) whose bottom is provided with the mounting terminal portion (62);
(b) a piezoelectric resonator (35) housing a piezoelectric resonator element (37) in a package (36) fixed on the upper surface of the substrate (60) and sealed with a lid (32), and having an external terminal portion (42) electrically coupled to the piezoelectric resonator element (37) on the surface of the package (36) by means of an electrode portion (40) exposed to an inner space of the package (36) ; and
(c) an oscillator circuit element (50) included in an oscillator circuit and fixed on a side of the package (36) opposite to the side facing the substrate (60);
(d) the substrate (60) including on its upper surface a conductive terminal portion (63a, 63b, 63c, 63d) electrically coupled to the mounting terminal portion (62) ; and
(e) the external terminal portion (42) and the conductive terminal portion (63a, 63b, 63c, 63d) being electrically coupled to the oscillator circuit element (50)
wherein
the piezoelectric resonator (35) is fixed to make the lid (32) face the upper surface of the substrate (60), and
the oscillator circuit element (50) is fixed to the side of the piezoelectric resonator (35) having the external terminal portion (42), and has terminal portions (51a, 51j) wire bonded to the external terminal portion (42) and the conductive terminal portion (63a, 63b, 63c, 63d).

3. The piezoelectric oscillator (30) according to Claim 2, wherein the substrate (60) includes a portion defining a hole in an area facing the lid (32).

4. The piezoelectric oscillator (30) according to any of Claims 1 through 3, wherein the substrate (60) includes a controlling terminal portion for writing a signal that controls operation of the piezoelectric resonator element (37) in the oscillator circuit element (50) on an upper surface, and
the controlling terminal portion and the oscillator circuit element (50) are coupled by wire bonding.

5. The piezoelectric oscillator (30) according to Claim 4, wherein a write-in terminal electrically coupled to the Controlling terminal portion is provided on a bottom of the substrate (60).

6. The piezoelectric oscillator (30) according to any of Claims 1 through 5, wherein an electrode is provided to a surface of the piezoelectric resonator (35), and between a terminal portion of the oscillator circuit element (50) and at least one of the external terminal portion (42) to be coupled to the terminal portion and a terminal on the substrate (60).

7. The piezoelectric oscillator (30) according to Claim 6, wherein the piezoelectric resonator (35) includes a conductive body along a thickness direction on a surface of the resonator, and through the conductive body the electrode pattern provided between a terminal portion of the oscillator circuit element (50) and a terminal on the substrate (60) is electrically coupled to the terminal on the substrate (60).

8. The piezoelectric oscillator (30) according to any of Claims 1 through 7, wherein the substrate (60) includes a concave portion in which the piezoelectric resonator (35) is fixed.

9. The piezoelectric oscillator (30) according to Claim 8, wherein part of the concave portion has a step-free portion.

10. The piezoelectric oscillator (30) according to Claim 8 or 9, wherein the substrate (60) includes a pair of walls so as to have the concave portion; and
ends of the walls are almost as high as the terminal portion of the oscillator circuit element (50).

11. The piezoelectric oscillator (30) according to any of Claims 1 through 10, wherein a surface of at least one of the substrate (60) and the piezoelectric resonator (35) includes a terminal portion electrically coupled to the oscillator circuit element (50).

12. The piezoelectric oscillator (30) according to any of Claims 1 through 11, wherein part of the mounting terminal portion (62) includes a portion defining a bottomed hole.

13. A method for manufacturing a piezoelectric oscillator (30) including a piezoelectric resonator (35) housing a piezoelectric resonator element (37) in a package (36) sealed with a lid (32) and having an external terminal portion (42) electrically coupled to the piezoelectric resonator element (37) by means of an electrode portion (40) exposed to an inner space of the package (36), on a surface of the package (36), and an oscillator circuit element (50) included in an oscillator circuit, comprising:
(a) providing a substrate (60) for preparing a plate substrate (60),
(b) providing a mounting terminal portion (62) to a bottom of the substrate (60), and
(c) providing a conductive terminal portion (63a, 63b, 63c, 63d) and a coupling terminal portion (65) to an upper surface of the substrate (60), the conductive terminal portion (63a, 63b, 63c, 63d) being electrically coupled to the mounting terminal portion (62), and the coupling terminal portion (65) provided in an area facing the external terminal portion (42) and extending out from the area to a periphery;
(d) mounting the piezoelectric resonator (35) on the upper surface of the substrate (60);
(e) fixing the element for fixing the oscillator circuit element (50) to the upper surface of the lid (32) and on a side of the package (36) opposite to the side facing the substrate (60);
(f) coupling for electrically coupling the external terminal portion (42) to the oscillator circuit element (50) and wire bonding for coupling terminal portions (51a,...51j) of the oscillator circuit element (50) to the conductive terminal portion (63a, 63b, 63c, 63d) and the coupling terminal portion (65); and
(g) sealing for sealing at least a conductive part, except for the mounting terminal portion (62), with resin (66);
(h) in providing the substrate (60), a substrate (60) large enough to place a plurality of piezoelectric resonators (35), each corresponding to the piezoelectric resonator (35), being provided, and the mounting, conductive, and coupling terminal portions (65) being formed to provide a plurality of piezoelectric oscillators (30), and
(i) mounting, fixing the element, bonding, and sealing being followed by cutting into individual piezoelectric oscillators (30).

14. A method for manufacturing a piezoelectric oscillator (30) including a piezoelectric resonator (35) housing a piezoelectric resonator element (37) in a package (36) sealed with a lid (32) and having an external terminal portion (42) electrically coupled to the piezoelectric resonator element (37) by means of an electrode portion (40) exposed to an inner space of the package (36), on a surface of the package (36), and an oscillator circuit element (50) included in an oscillator circuit, comprising:
(a) providing a substrate (60) for preparing a plate substrate (60),
(b) providing a mounting terminal portion (62) to a bottom of the substrate (60), and
(c) providing a conductive terminal portion (63a, 63b, 63c, 63d) electrically coupled to the mounting terminal portion (62) to an upper surface of the substrate (60);
(d) mounting the piezoelectric resonator on the (35) upper surface of the substrate to make the lid (32) face the upper surface of the substrate (60);
(e) fixing an element for fixing the oscillator circuit element (50) to a side of the package (36) having the external terminal portion (42), said side being opposite to the side facing the substrate;
(f) wire bonding for coupling terminal portions (51a,...51j) of the oscillator circuit element (50) with the conductive terminal portion (63a, 63b, 63c, 63d) and the external terminal portion (42); and
(g) sealing for sealing at least a conductive part, except for the mounting terminal portion (62), with resin (66);
(h) in providing the substrate (60), a substrate (60) large enough to place a plurality of piezoelectric resonators (35), each corresponding to the piezoelectric resonator (35), being provided, the mounting and conductive terminal portions (63a, 63b, 63c, 63d) being formed to provide a plurality of piezoelectric oscillators (30), and
(i) mounting, fixing the element, bonding, and sealing being followed by cutting into individual piezoelectric oscillators (30).

15. The method for manufacturing a piezoelectric oscillator (30) according to Claim 13 or 14, wherein in providing the substrate (60), a portion defining a through-hole is provided to the substrate (60), a conductive member is filled in the through-hole, and the mounting terminal portion (62) and the conductive terminal portion (63a, 63b, 63c, 63d) are electrically coupled through the conductive member.

## Patentansprüche

1. Piezoelektrischer Oszillator (30), bei dem zumindest ein leitfähiges Teil, mit der Ausnahme eines Montageanschlussbereichs (62) mit Polymer (66) abgedichtet ist, umfassend:
(a) ein Substrat (60), dessen Boden mit dem Montageanschlussbereich (62) versehen ist;
(b) ein piezoelektrischer Resonator (35), der ein piezoelektrisches Resonatorelement (37) in einer Packung (36) aufnimmt, die auf der oberen Oberfläche des Substrates (60) fixiert und mit einem Deckel (32) abgedichtet ist, und der einen externen Anschlussbereich (42) elektrisch mit dem piezoelektrischen Resonatorelement (37) auf der Oberfläche der Packung (36) mittels eines gegenüber dem Innenraum der Packung (36) exponierten Elektrodenbereichs (40) gekoppelt aufweist; und
(c) ein Oszillator-Schaltungselement (50), das in einer Oszillatorschaltung enthalten ist und auf einer Seite der Packung (36) gegenüberliegend der dem Substrat (60) zugewandten Seite fixiert ist;
(d) wobei das Substrat (60) auf seiner oberen Oberfläche einen leitfähigen Anschlussbereich (63a, 63b, 63c, 63d) beinhaltet, der elektrisch mit dem Montageanschlussbereich (62) gekoppelt ist; und
(e) der externe Anschlussbereich (42) und der leitfähige Anschlussbereich (63a, 63b, 63c, 63d) elektrisch mit dem Oszillator-Schaltungselement (50) gekoppelt sind,
wobei
der piezoelektrische Resonator (35) fixiert ist, um den externen Anschlussbereich dazu zu bringen, zur oberen Oberfläche des Substrats (60) zu weisen;
das Oszillator-Schaltungselement (50) an der Oberfläche des Deckels (32) fixiert ist, der in dem piezoelektrischen Resonator (35) beinhaltet ist,
das Substrat (60) einen in einem zum externen Anschlussbereich (42) weisenden Flächenbereich Kopplungsanschlussbereich (65) beinhaltet und sich von dem Flächenbereich zu einer Peripherie erstreckt, und der Kopplungsanschlussbereich (65) und der leitfähige Anschlussbereich (63a, 63b, 63c, 63d) mit Anschlussbereichen (51a, ... 51j) des Oszillator-Schaltungselements (50) Draht-gebondet sind.

2. Piezoelektrischer Oszillator (30), bei dem zumindest ein leitfähiger Teil außer einem Motoranschlussbereich (62) mit Polymer (66) abgedichtet ist, umfassend:
(a) ein Substrat (60), dessen Boden mit dem Montageanschlussbereich (62) versehen ist;
(b) ein piezoelektrischer Resonator (35), der ein piezoelektrisches Resonatorelement (37) in einer Packung (36) aufnimmt, die auf der oberen Oberfläche des Substrates (60) fixiert und mit einem Deckel (32) abgedichtet ist, und der einen externen Anschlussbereich (42) elektrisch mit dem piezoelektrischen Resonatorelement (37) auf der Oberfläche der Packung (36) mittels eines gegenüber dem Innenraum der Packung (36) exponierten Elektrodenbereichs (40) gekoppelt aufweist; und
(c) ein Oszillator-Schaltungselement (50), das in einer Oszillatorschaltung enthalten ist und auf einer Seite der Packung (36) gegenüberliegend der dem Substrat (60) zugewandten Seite fixiert ist;
(d) wobei das Substrat (60) auf seiner oberen Oberfläche einen leitfähigen Anschlussbereich (63a, 63b, 63c, 63d) beinhaltet, der elektrisch mit dem Montageanschlussbereich (62) gekoppelt ist; und
(e) der externe Anschlussbereich (42) und der leitfähige Anschlussbereich (63a, 63b, 63c, 63d) elektrisch mit dem Oszillator-Schaltungselement (50) gekoppelt sind,
wobei
der piezoelektrische Resonator (35) so fixiert ist, dass er den Deckel (32) dazu bringt, zur oberen Oberfläche des Substrats (60) hinzuweisen, und
das Oszillator-Schaltungselement (50) an der Seite des piezoelektrischen Resonators (35) fixiert ist, der den externen Anschlussbereich (42) aufweist, und Anschlussbereiche (51a, 51j) aufweist, die mit dem externen Anschlussbereich (42) und dem leitfähigen Anschlussbereich (63a, 63b, 63c, 63d) Draht-gebondet sind.

3. Piezoelektrischer Oszillator (30) gemäß Anspruch 2, wobei das Substrat (60) einen Bereich beinhaltet, der ein Loch in einem zum Deckel (32) hinweisenden Flächenbereich definiert.

4. Piezoelektrischer Oszillator (30) gemäß einem der Ansprüche 1 bis 3, wobei das Substrat (60) einen Steuerungsanschlussbereich zum Schreiben eines Signals beinhaltet, das den Betrieb des piezoelektrischen Resonatorelementes (37) im Oszillator-Schaltungselement (50) auf einer oberen Oberfläche steuert, und
der Steueranschlussbereich und das Oszillator-Schaltungselement (50) durch Drahtbondierung gekoppelt sind.

5. Piezoelektrischer Oszillator (30) gemäß Anspruch 4, wobei ein elektrisch mit dem Steueranschlussbereich gekoppelter Einschreibanschluss auf einem Boden des Substrats (60) vorgesehen ist.

6. Piezoelektrischer Oszillator (30) gemäß einem der Ansprüche 1 bis 5, wobei eine Elektrode an einer Oberfläche des piezoelektrischen Resonators (35) vorgesehen ist und zwischen einem Anschlussbereich des Oszillator-Schaltungselements (50) und dem mit dem Anschlussbereich zu koppelnden externen Anschlussbereich (42) und/oder einem Anschluss des Substrats (60) vorgesehen ist.

7. Piezoelektrischer Oszillator (30) gemäß Anspruch 6, wobei der piezoelektrische Resonator (35) einen leitfähigen Körper längs der Dickenrichtung auf einer Oberfläche des Resonators beinhaltet, und durch den leitfähigen Körper das zwischen einem Anschlussbereich des Oszillator-Schaltungselements (50) und einem Anschluss auf dem Substrat (60) vorgesehene Elektrodenmuster elektrisch mit dem Anschluss auf dem Substrat (60) gekoppelt ist.

8. Piezoelektrischer Oszillator (30) gemäß einem der Ansprüche 1 bis 7, wobei das Substrat (60) einen konkaven Bereich beinhaltet, in dem der piezoelektrische Resonator (35) fixiert ist.

9. Piezoelektrischer Oszillator (30) gemäß Anspruch 8, wobei ein Teil des konkaven Bereichs einen stufenfreien Bereich aufweist.

10. Piezoelektrischer Oszillator (30) gemäß Anspruch 8 oder 9, wobei das Substrat (60) ein Paar Wände beinhaltet, um so den konkaven Bereich aufzuweisen; und
Enden der Wände fast so hoch wie der Anschlussbereich des Oszillator-Schaltungselements (50) sind.

11. Piezoelektrischer Oszillator (30) gemäß einem der Ansprüche 1 bis 10, wobei eine Oberfläche des Substrats (60) und/oder des piezoelektrischen Resonators (35) einen elektrisch mit dem Oszillator-Schaltungselement (50) gekoppelten Anschlussbereich beinhaltet.

12. Piezoelektrischer Oszillator (30) gemäß einem der Ansprüche 1 bis 11, wobei Teil des Motoranschlussbereichs (62) einen ein mit Boden versehenes Loch definierenden Bereich aufweist.

13. Verfahren zur Herstellung eines piezoelektrischen Oszillators (30), der beinhaltet einen piezoelektrischen Resonator (35), der ein piezoelektrisches Resonatorelement (37) in einer Packung (36) aufnimmt, die mit einem Deckel (32) abgedichtet ist und einen externen Anschlussbereich (42) elektrisch mit dem piezoelektrischen Resonatorelement (37) mittels eines zu einem Innenraum der Packung (36) exponierten Elektrodenbereich (40) gekoppelt, auf einer Oberfläche der Packung (36) aufweist, und ein in einer Oszillatorschaltung beinhaltetes Oszillator-Schaltungselement (50), umfassend:
(a) Bereitstellen eines Substrats (60) zum Vorbereiten eines Plattensubstrats (60),
(b) Bereitstellen eines Montageanschlussbereichs (62) an einem Boden des Substrats (60), und
(c) Bereitstellen eines leitfähigen Anschlussbereichs (63a, 63b, 63c, 63d) und eines Kopplungsanschlussbereichs (65) an einer oberen Oberfläche des Substrats (60), wobei der leitfähige Anschlussbereich (63a, 63b, 63c, 63d) elektrisch mit dem Montageanschlussbereich (62) gekoppelt ist und der Kopplungsanschlussbereich (64) in einem Flächenbereich vorgesehen ist, der zum externen Anschlussbereich (42) hinweist und sich von dem Flächenbereich zu einer Peripherie heraus erstreckt,
(d) Montieren des piezoelektrischen Resonators (35) auf der oberen Oberfläche des Substrats (60);
(e) Fixieren des Elementes zum Fixieren des Oszillator-Schaltungselements (50) an der oberen Oberfläche des Deckels (32) und auf einer Seite der Packung (36) gegenüberliegend der Seite, die zum Substrat (60) hinweist;
(f) Koppeln zur elektrischen Kopplung des externen Anschlussbereichs (42) mit dem Oszillator-Schaltungselement (50) und Draht-Bondieren zum Kuppeln von Anschlussbereichen (51, ... 51j) des Oszillator-Schaltungselements (50) mit dem leitfähigen Anschlussbereich (63a, 63b, 63c, 63d) und dem Kopplungsanschlussbereich (65); und
(g) Dichten zum Abdichten zumindest eines leitfähigen Teils, außer dem Montageanschlussbereich (62), mit Polymer (66);
(h) beim Bereitstellen des Substrats (60), ein Substrat (60), das ausreichend groß ist, um eine Mehrzahl von piezoelektrischen Resonatoren (35) zu platzieren, die alle dem piezoelektrischen Resonator (35) entsprechen, vorgesehen ist, und die Montage-, leitfähigen und Kopplungsanschlussbereiche (65) ausgeformt sind, um eine Mehrzahl von piezoelektrischen Oszillatoren (30) bereitzustellen, und
(i) dem Montieren, Befestigen des Elements, Bondieren und Abdichten ein Schneiden in einzelne piezoelektrische Oszillatoren (30) folgt.

14. Verfahren zur Herstellung eines piezoelektrischen Oszillators (30), der beinhaltet einen piezoelektrischen Resonator (35), der ein piezoelektrisches Resonatorelement (37) in einer Packung (36) aufnimmt, die mit einem Deckel (32) abgedichtet ist und einen externen Anschlussbereich (42) elektrisch mit dem piezoelektrischen Resonatorelement (37) mittels eines zu einem Innenraum der Packung (36) exponierten Elektrodenbereich (40) gekoppelt, auf einer Oberfläche der Packung (36) aufweist, und ein in einer Oszillatorschaltung beinhaltetes Oszillator-Schaltungselement (50), umfassend:
(a) Bereitstellen eines Substrats (60) zum Vorbereiten eines Plattensubstrats (60),
(b) Bereitstellen eines Montageanschlussbereichs (62) an einem Boden des Substrats (60), und
(c) Bereitstellen eines leitfähigen Anschlussbereichs (63a, 63b, 63c, 63d), der elektrisch mit dem Montageanschlussbereich (62) auf einer oberen Oberfläche des Substrats (60) gekoppelt ist;
(d) Montieren des piezoelektrischen Resonators auf der oberen Oberfläche des Substrats (35), um den Deckel (32) dazu zu bringen, zur oberen Oberfläche des Substrats (60) zu weisen;
(e) Fixieren eines Elementes zum Fixieren des Oszillator-Schaltungselements (50) auf einer Seite der Packung (36), die den externen Anschlussbereich (42) aufweist, wobei die Seite gegenüberliegend der zum Substrat weisenden Seite ist;
(f) Drahtbondieren zum Koppeln von Anschlussbereichen (51a, ... 51j) des Oszillator-Schaltungselements (50) mit dem leitfähigen Anschlussbereich (63a, 63b, 63c, 63d) und dem externen Anschlussbereich (42); und
(g) Abdichten zum Abdichten zumindest eines leitfähigen Teils, außer dem Montageanschlussbereich (62), mit Polymer (66);
(h) beim Bereitstellen des Substrats (60), ein Substrat (60), das ausreichend groß ist, um eine Mehrzahl von piezoelektrischen Resonatoren (35) zu platzieren, die alle dem piezoelektrischen Resonator (35) entsprechen, vorgesehen ist, und die Montage-, leitfähigen und Kopplungsanschlussbereiche (65) ausgeformt sind, um eine Mehrzahl von piezoelektrischen Oszillatoren (30) bereitzustellen, und
(i) dem Montieren, Befestigen des Elements, Bondieren und Abdichten ein Schneiden in einzelne piezoelektrische Oszillatoren (30) folgt.

15. Verfahren zur Herstellung eines piezoelektrischen Oszillators (30) gemäß Anspruch 13 oder 14, wobei beim Bereitstellen des Substrats (60) ein Bereich, der ein Durchgangsloch definiert, am Substrat (60) vorgesehen ist, ein leitfähiges Element in das Durchgangsloch gefüllt wird und der Montageanschlussbereich (62) und der leitfähige Anschlussbereich (63a, 63b, 63c, 63d) elektrisch durch das leitfähige Element gekoppelt sind.

## Revendications

1. Oscillateur piézoélectrique (30), dans lequel au moins une partie conductrice à l'exception d'une partie (62) de borne de montage est scellée avec de la résine (66), comprenant :
(a) un substrat (60) dont le fond est doté de la partie (62) de borne de montage ;
(b) un résonateur piézoélectrique (35) recevant un élément (37) de résonateur piézoélectrique dans un boîtier (36) fixé sur la surface supérieure du substrat (60) et scellé avec un couvercle (32), et ayant une partie (42) de borne externe couplée électriquement à l'élément (37) de résonateur piézoélectrique sur la surface du boîtier (36) au moyen d'une partie d'électrode (40) exposée à un espace interne du boîtier (36) ; et
(c) un élément (50) de circuit oscillateur compris dans un circuit oscillateur et fixé sur un côté du boîtier (36) opposé au côté en vis-à-vis du substrat (60) ;
(d) le substrat (60) comportant sur sa surface supérieure une partie (63a, 63b, 63c, 63d) de borne conductrice couplée électriquement à la partie (62) de borne de montage, et
(e) la partie (42) de borne externe et la partie (63a, 63b, 63c, 63d) de borne conductrice étant couplées électriquement à l'élément (50) de circuit oscillateur,
où
le résonateur piézoélectrique (35) est fixé pour que la partie de borne externe se trouve en vis-à-vis de la surface supérieure du substrat (60),
l'élément (50) de circuit oscillateur est fixé à la surface supérieure du couvercle (32) compris dans le résonateur piézoélectrique (35),
le substrat (60) comporte une partie (65) de borne de couplage pourvue dans une zone en vis-à-vis de la partie (42) de borne externe, et s'étend depuis la zone vers une périphérie, et
la partie (65) de borne de couplage et la partie (63a, 63b, 63c, 63d) de borne conductrice sont liées par micro-câblage à des parties de borne (51a, ... 51j) de l'élément (50) de circuit oscillateur.

2. Oscillateur piézoélectrique (30), où au moins une partie conductrice à l'exception d'une partie (62) de borne de montage est scellée avec de la résine (66), comprenant :
(a) un substrat (60) dont le fond est doté de la partie (62) de borne de montage ;
(b) un résonateur piézoélectrique (35) recevant un élément (37) de résonateur piézoélectrique dans un boîtier (36) fixé sur la surface supérieure du substrat (60) et scellé avec un couvercle (32), et ayant une partie (42) de borne externe couplée électriquement à l'élément (37) de résonateur piézoélectrique sur la surface du boîtier (36) au moyen d'une partie d'électrode (40) exposée à un espace interne du boîtier (36) ; et
(c) un élément (50) de circuit oscillateur compris dans un circuit oscillateur et fixé sur un côté du boîtier (36) opposé à un côté en vis-à-vis du substrat (60) ;
(d) le substrat (60) comportant sur sa surface supérieure une partie (63a, 63b, 63c, 63d) de borne conductrice couplée électriquement à la partie (62) de borne de montage ; et
(e) la partie (42) de borne externe et la partie (63a, 63b, 63c, 63d) de borne conductrice étant couplées électriquement à l'élément (50) de circuit oscillateur
où
le résonateur piézoélectrique (35) est fixé pour que le couvercle (32) se trouve en vis-à-vis de la surface supérieure du substrat (60), et
l'élément (50) de circuit oscillateur est fixé au côté du résonateur piézoélectrique (35) ayant la partie (42) de borne externe, et a des parties de bornes (51a, 51j) liées par micro-câblage à la partie (42) de borne externe et à la partie (63a, 63b, 63c, 63d) de borne conductrice.

3. Oscillateur piézoélectrique (30) selon la revendication 2, où le substrat (60) comporte une partie définissant un trou dans une zone en vis-à-vis du couvercle (32).

4. Oscillateur piézoélectrique (30) selon l'une des revendications 1 à 3, où le substrat (60) comporte une partie de borne de commande destinée à écrire un signal qui commande le fonctionnement de l'élément (37) de résonateur piézoélectrique dans l'élément (50) de circuit oscillateur sur une surface supérieure ; et
la partie de borne de commande et l'élément (50) de circuit oscillateur sont couplés par micro-câblage.

5. Oscillateur piézoélectrique (30) selon la revendication 4,
où une borne de lecture couplée électriquement à la partie de borne de commande est pourvue sur une partie inférieure du substrat (60).

6. Oscillateur piézoélectrique (30) selon l'une des revendications 1 à 5, où une électrode est pourvue à une surface du résonateur piézoélectrique (35), et entre une partie de borne de l'élément (50) de circuit oscillateur et au moins l'une de la partie (42) de borne externe à raccorder à la partie de borne et à une borne sur le substrat (60).

7. Oscillateur piézoélectrique (30) selon la revendication 6, où le résonateur piézoélectrique (35) comporte un corps conducteur le long d'une direction d'épaisseur sur une surface du résonateur, et le motif d'électrode pourvu entre une partie de borne de l'élément (50) de circuit oscillateur et une borne sur le substrat (60) est électriquement couplé à la borne sur le substrat (60) à travers le corps conducteur.

8. Oscillateur piézoélectrique (30) selon l'une des revendications 1 à 7, où le substrat (60) comporte une partie concave dans laquelle le résonateur piézoélectrique (35) est fixé.

9. Oscillateur piézoélectrique (30) selon la revendication 8, où une partie de la partie concave a une partie non étagée.

10. Oscillateur piézoélectrique (30) selon la revendication 8 ou 9, où le substrat (60) comporte une paire de parois de sorte à disposer de la partie concave ; et
des extrémités des parois sont presque aussi hautes que la partie de borne de l'élément (50) de circuit oscillateur.

11. Oscillateur piézoélectrique (30) selon l'une des revendications 1 à 10, où une surface d'au moins l'un du substrat (60) et du résonateur électrique (35) comporte une partie de borne couplée électriquement à l'élément (50) de circuit oscillateur.

12. Oscillateur piézoélectrique (30) selon l'une des revendications 1 à 11, où une partie de la partie (62) de borne de montage comporte une partie définissant un trou inférieur.

13. Procédé de fabrication d'un oscillateur piézoélectrique (30) comportant un résonateur piézoélectrique (35) recevant un élément (37) de résonateur piézoélectrique dans un boîtier (36) scellé avec un couvercle (32) et ayant une partie (42) de borne externe couplée électriquement à l'élément (37) de résonateur piézoélectrique au moyen d'une partie d'électrode (40) exposée à un espace interne du boîtier (36), sur une surface du boîtier (36), et un élément (50) de circuit oscillateur compris dans un circuit oscillateur, comprenant le fait :
(a) de prévoir un substrat (60) pour préparer un substrat en plaque (60),
(b) de prévoir une partie (62) de borne de montage (62) au niveau d'un fond du substrat (60), et
(c) de prévoir une partie (63a, 63b, 63c, 63d) de borne conductrice et une partie (65) de borne de couplage à une surface supérieure du substrat (60), la partie (63a, 63b, 63c, 63d) de borne conductrice étant couplée électriquement à la partie (62) de borne de montage, et la partie (65) de borne de couplage pourvue dans une zone en vis-à-vis de la partie (42) de borne externe et s'étendant en dehors de la zone vers une périphérie ;
(d) de monter le résonateur piézoélectrique (35) sur la surface supérieure du substrat (60) ;
(e) de fixer l'élément afin de fixer l'élément (50) de circuit oscillateur à la surface supérieure du couvercle et sur un côté du boîtier (36) opposé au côté en vis-à-vis du substrat (60) ;
(f) de coupler, afin de coupler électriquement la partie (42) de borne externe à l'élément (50) de circuit oscillateur et de lier par micro-câblage pour coupler des parties de borne (51a, ..., 51j) de l'élément (50) de circuit oscillateur à la partie (63a, 63b, 63c, 63d) de borne conductrice et à la partie (65) de borne de couplage ; et
(g) d'assurer un scellement pour sceller au moins une partie conductrice, à l'exception de la partie (62) de borne de montage, avec de la résine (66) ;
(h) en prévoyant le substrat (60), on fourni un substrat (60) suffisamment, grand pour placer une pluralité de résonateurs piézoélectriques (35), correspondant chacun au résonateur piézoélectrique (35), et des parties (65) de borne de montage, conductrices, et de couplage étant formées pour prévoir une pluralité d'oscillateurs piézoélectriques (30), et
(i) de monter, fixer l'élément, faire liaison, et sceller suivis par le découpage en des oscillateurs piézoélectriques individuels (30).

14. Procédé de fabrication d'un oscillateur piézoélectrique (30) comportant un résonateur piézoélectrique (35) recevant un élément (37) de résonateur piézoélectrique dans un boîtier (36) scellé avec un couvercle (32) et ayant une partie (42) de borne externe couplée électriquement à l'élément (37) de résonateur piézoélectrique au moyen d'une partie d'électrode (40) exposée à un espace interne du boîtier (36), sur une surface du boîtier (36), et un élément (50) de circuit oscillateur compris dans un circuit oscillateur, comprenant le fait :
(a) de prévoir un substrat (60) pour préparer un substrat en plaque (60),
(b) de prévoir une partie (62) de borne de montage au niveau d'un fond du substrat (60), et
(c) de prévoir une partie (63a, 63b, 63c, 63d) de borne conductrice couplée électriquement à la partie (62) de borne de montage à une surface supérieure du substrat (60) ;
(d) de monter le résonateur piézoélectrique (35) sur la surface supérieure du substrat pour que le couvercle (32) se trouve en vis-à-vis de la surface supérieure du substrat (60) ;
(e) de fixer un élément afin de fixer l'élément (50) de circuit oscillateur à un côté du boîtier (36) ayant la partie (42) de borne externe, ledit côté étant opposé au côté en vis-à-vis du substrat ;
(f) d'effectuer une liaison par micro-câblage pour coupler des parties de borne (51a, ..., 51j) de l'élément (50) de circuit oscillateur avec la partie (63a, 63b, 63c, 63d) de borne conductrice et la partie (42) de borne externe ; et
(g) d'assurer un scellement pour sceller au moins une partie conductrice, à l'exception de la partie (62) de borne de montage, avec de la résine (66) ;
(h) en prévoyant le substrat (60), on fourni un substrat (60) suffisamment grand pour placer une pluralité de résonateurs piézoélectriques (35), correspondant chacun au résonateur piézoélectrique (35), et les parties (63a, 63b, 63c, 63d) de borne de montage et conductrices, étant formées pour prévoir une pluralité d'oscillateurs piézoélectriques (30), et
(i) de monter, fixer l'élément, lier, et sceller suivis par un découpage en des oscillateurs piézoélectriques individuels (30).

15. Procédé de fabrication d'un oscillateur piézoélectrique (30) selon la revendication 13 ou 14, où en fournissant le substrat (60), une partie définissant un trou traversant est pourvue au substrat (60), un élément conducteur est chargé dans le trou traversant, et la partie (62) de borne de montage et la partie (63a, 63b, 63c, 63d) de borne conductrice sont couplées électriquement à travers l'élément conducteur.
